# FASCICULE DE BREVET EUROPEEN

(11) **EP 2 706 660 B1**
(45) Date de publication et mention de la délivrance du brevet: **25.11.2015**
(21) Numéro de dépôt: 12183182.0
(22) Date de dépôt: 05.09.2012
(51) Int. Cl.: H01Q 3/26, H04B 7/04, H04B 7/06, H03C 1/04

(54) **Dispositif d'émission de signaux de données et/ou de commande avec des agencements d'antenne**
Vorrichtung zum Senden von Datensignalen und/oder Steuern mit Antennenanordnungen
Device for transmitting data and/or control signals with antenna arrangements

(43) Date de publication de la demande: 12.03.2014
(73) Titulaire: Swiss Timing Ltd., 2606 Corgémont (CH)
(72) Inventeur: Bisig, Martin, 4528 Zuchwil (CH)
(74) Mandataire: Ravenel, Thierry Gérard Louis

(56) Documents cités:
- WO-A1-2005/029801
- US-A1- 2002 034 191

## Description

### DOMAINE TECHNIQUE

L'invention concerne un dispositif d'émission de signaux de données et/ou de commande, qui utilise un ensemble d'antennes en particulier de petite dimension pour la transmission combinée desdits signaux. Ce dispositif d'émission est principalement utilisé pour la transmission de signaux à longues ou moyennes ondes, comme par exemple pour des systèmes à transpondeurs.

### ARRIERE-PLAN TECHNOLOGIQUE

Pour la transmission de signaux de données ou de commande, des antennes de transmission doivent être en mesure d'irradier ou de rayonner un ou plusieurs signaux électriques avec un minimum de pertes et avec une largeur de bande bien appariée. Ainsi toutes les composantes spectrales des signaux électriques sont rayonnées de la meilleure des façons.

Pour de petites antennes électriques, c'est-à-dire des antennes, qui ont une taille physique bien plus petite que la longueur d'onde du signal de transmission, un compromis doit être défini entre la perte de puissance et la largeur de bande des signaux à transmettre. En règle générale pour de petites antennes à largeur de bande raisonnable, le produit entre la perte de puissance et la largeur de bande des signaux doit être constant. Cette propriété peut aussi être expliquée par l'expression du facteur de qualité de l'antenne Q.

Quelques développements pour réaliser des antennes au-delà de cette limite fonctionnelle, ont déjà été effectués, mais sans aboutir à un fonctionnement comme espéré. Ainsi, il n'existe pas d'antennes de transmission, qui sont capables de rayonner des signaux électriques avec un bon facteur de qualité Q en tenant compte de la limite de Chu. Cette limite de Chu pour des antennes traditionnelles décrit le facteur de qualité minimum, et par conséquent la largeur de bande maximum en fonction de la taille de l'antenne traditionnelle. Cette limite de Chu bien connue pour le développement desdites antennes, se base sur l'hypothèse que ladite antenne est passive, linéaire et petite.

Pour déterminer précisément un tel facteur de qualité Q, on peut se référer à l'article intitulé "A re-examination of the fundamental limits on the radiation Q of electrically small antennas" de M. Mc Lean J. S., dans la revue IEEE transaction on antennas and propagation, de 1996, vol. 44, issue 5. Quelques réalisations de petites antennes sont également décrites dans l'article intitulé "Electrically small super-directive and super-conductive antennas" de M. R. C. Hansen, dans le bouquin Whiley de 2006, pages 62 à 84.

La demande de brevet US 2002/0034191 A1 définit un système de transmission d'ondes électro-magnétiques. Il est effectué une superposition de plusieurs ondes à fréquence différente dans un intervalle de temps déterminé, mais qui est compliqué pour effectuer une modulation de données dans les ondes transmises.

La demande de brevet WO 2005/029801 A1, définit un appareil pour la transmission de signaux modulés à plusieurs fréquences au moyen de trois antennes. Il n'explique pas la combinaison des signaux par des agencements d'antenne pour opérer une modulation en amplitude.

### RESUME DE L'INVENTION

L'invention a donc pour but de pallier aux inconvénients de l'état de la technique susmentionné en proposant un dispositif d'émission de signaux de données et/ou de commande avec des antennes de petite dimension à haut facteur de qualité, à largeur de bande au-delà de la limite Chu et capables de transmettre des signaux électromagnétiques avec une relativement faible perte de puissance.

A cet effet, l'invention concerne un dispositif d'émission de signaux de données et/ou de commande, qui comprend les caractéristiques définies dans la revendication indépendante 1.

Des formes d'exécution particulières du dispositif d'émission de signaux de données et/ou de commande sont définies dans les revendications dépendantes 2 à 15.

Un avantage du dispositif d'émission de signaux de données et/ou de commande, réside dans le fait que la commutation de fréquence pour la modulation en amplitude des signaux transmis par les agencements d'antenne est effectuée de manière synchrone avec une adaptation dynamique de la fréquence de résonance des agencements d'antenne.

Avantageusement, l'adaptation de la fréquence de résonance d'au moins un agencement d'antenne peut être effectuée par l'ajout ou le retrait d'un condensateur complémentaire en parallèle d'un condensateur lié en série avec une inductance et une résistance de perte. La commutation synchrone de fréquence pour la modulation des données est ainsi effectuée à un passage par zéro de la tension sur chaque condensateur. Ceci permet d'utiliser des antennes à boucles à haut facteur de qualité Q et d'éviter toute réponse transitoire lors de la transition d'état de modulation.

Avantageusement, le dispositif d'émission de la présente invention permet de réaliser une transition de symboles ou d'états de modulation dans les signaux modulés ayant une forme de cosinus. Cela permet d'avoir une influence avantageuse sur l'efficacité spectrale des signaux transmis.

A cet effet, l'invention concerne également un procédé de mise en action d'un dispositif d'émission de signaux de données et/ou de commande, qui comprend les caractéristiques définies dans la revendication indépendante 16.

### BREVE DESCRIPTION DES DESSINS

Les buts, avantages et caractéristiques du dispositif d'émission de signaux de données et/ou de commande selon l'invention, et de son procédé de mise en action, apparaîtront mieux dans la description suivante de formes d'exécution non limitatives illustrées par les dessins sur lesquels :
la figure 1 représente de manière générale les différents composants d'un dispositif d'émission de signaux de données et/ou de commande selon l'invention,
la figure 2 représente un diagramme temporel de signaux transmis par les antennes pour la modulation en amplitude des données et/ou de commande du dispositif d'émission de signaux de données et/ou de commande selon l'invention,
la figure 3 représente une première forme d'exécution du dispositif d'émission de signaux de données et/ou de commande selon l'invention,
la figure 4 représente une seconde forme d'exécution du dispositif d'émission de signaux de données et/ou de commande selon l'invention, et
les figures 5a et 5b représentent deux graphiques comparatifs du spectre de la modulation en amplitude des données dans les signaux transmis par une antenne avec commutation synchrone au passage du courant par 0 A, et par des agencements d'antenne selon la présente invention.

### DESCRIPTION DETAILLEE DE L'INVENTION

Dans la description suivante, tous les éléments du dispositif d'émission de signaux de données et/ou de commande, qui sont bien connus de l'homme du métier dans ce domaine technique, ne seront relatés que de manière simplifiée.

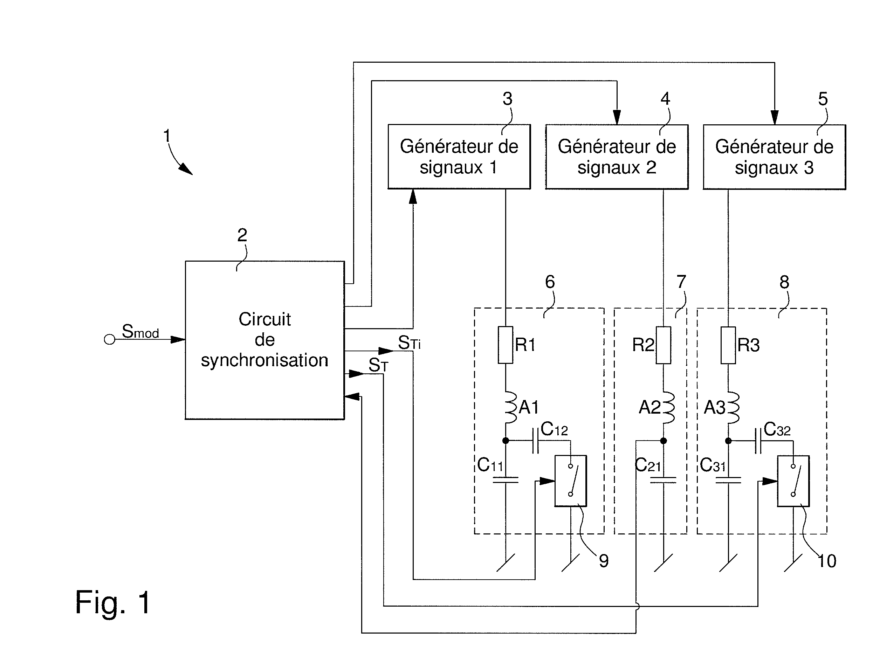

La figure 1 représente de manière simplifiée un dispositif d'émission 1 de signaux de données et/ou de commande. Ce dispositif d'émission 1 peut être utilisé pour la transmission de signaux de données et/ou de commande à destination d'un ensemble de transpondeurs pour une compétition sportive par exemple ou à des stations radios. Chaque transpondeur muni d'une antenne de côté peut être porté notamment par un compétiteur de manière à recevoir des informations depuis le dispositif d'émission 1 de la présente invention. De préférence, les signaux de données et/ou de commande transmis par le dispositif d'émission 1 peuvent avoir une fréquence porteuse située dans le domaine des basses fréquences. Cette fréquence porteuse peut être de l'ordre de 128 kHz. Le débit des données transmises dans les signaux peut être de l'ordre de 16.5 kbit/s. Les signaux sont transmis avec une largeur de bande de l'ordre de 4 kHz, ce qui convient à un système à transpondeurs.

Le dispositif d'émission 1 transmet des signaux à modulation d'amplitude des données et/ou de commande. La modulation d'amplitude peut être du type tout ou rien (ON-OFF Keying en terminologie anglaise) ou à deux niveaux d'amplitude définis (Amplitude Shift Keying en terminologie anglaise). Pour ce faire, il est prévu d'effectuer la modulation d'amplitude des données et/ou de commande directement par l'intermédiaire de deux ou trois antennes A1, A2, A3 du dispositif d'émission par combinaison ou addition des signaux transmis par chaque antenne. Les antennes sont commandées indépendamment l'une de l'autre. La superposition des signaux transmis peut être destructive en fonction du déphasage des signaux dépendant de l'état de données et/ou de commande à transmettre. Ceci permet par combinaison ou addition des signaux transmis en phase ou déphasés d'obtenir une modulation en amplitude des données et/ou de commande à transmettre. Toute perte de puissance de transmission est également réduite en utilisant l'ensemble des antennes, qui agissent en plus du rayonnement des signaux électromagnétiques en tant qu'ensemble modulateur de données et/ou de commande à transmettre.

De manière générale, le dispositif d'émission 1 comprend un circuit de synchronisation 2, un premier générateur de signaux 3 pour commander un premier agencement d'antenne 6, un second générateur de signaux 4 pour commander un second agencement d'antenne 7, et un troisième générateur de signaux 5 pour commander un troisième agencement d'antenne 8. Un oscillateur non représenté est également prévu pour cadencer de manière synchrone les trois générateurs de signaux 3, 4, 5. Cet oscillateur peut faire partie du circuit de synchronisation 2, qui dans ce cas contrôle les trois générateurs de signaux, mais de préférence l'oscillateur est compris dans le second générateur de signaux 4. Si l'oscillateur est compris dans le second générateur de signaux, un signal de cadencement synchrone est fourni depuis le second générateur de signaux 4 à destination du premier générateur de signaux 3 et du troisième générateur de signaux 5.

Sans aucune modulation en amplitude des données et/ou de commande ou dans un état stable de modulation, tous les signaux de forme sinusoïdale, transmis par les agencements d'antenne 6, 7 et 8 sont à une même fréquence porteuse f0. Pour effectuer la modulation en amplitude des données et/ou de commande, la fréquence des signaux fournis par les premier et troisième générateurs 3, 5 est modifiée temporairement par rapport à la fréquence porteuse des signaux du second générateur 4 lors de chaque transition d'état de modulation. La modification de fréquence des signaux fournis par les premier et troisième générateurs de signaux 3, 5 s'opère temporairement lors de la phase de transition d'un premier état à un second état de la modulation de données et/ou de commande. Un premier état peut définir un état "1 ", alors qu'un second état peut définir un état "0", ou inversement.

Lors de chaque phase de transition d'état de modulation, les signaux fournis au premier agencement d'antenne 6 par le premier générateur de signaux 3 sont temporairement à une fréquence égale à f1=f0-Δf pendant un certain nombre de cycles des signaux du second générateur de signaux 4, qui restent à une fréquence porteuse égale à f0. Les signaux fournis au troisième agencement d'antenne 8 par le troisième générateur de signaux 5 sont également temporairement à une fréquence égale à f3=f0+Δf pendant un certain nombre de cycles des signaux du second générateur de signaux 4. Après ce certain nombre de cycles, la fréquence des signaux fournis par les trois générateurs sont rétablis à une même fréquence porteuse f0.

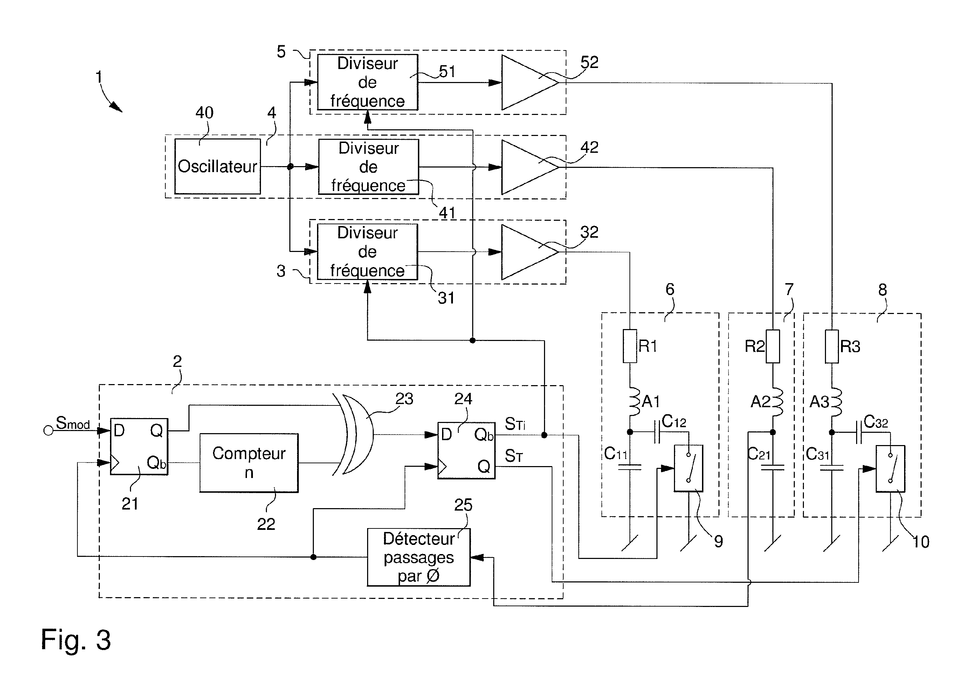

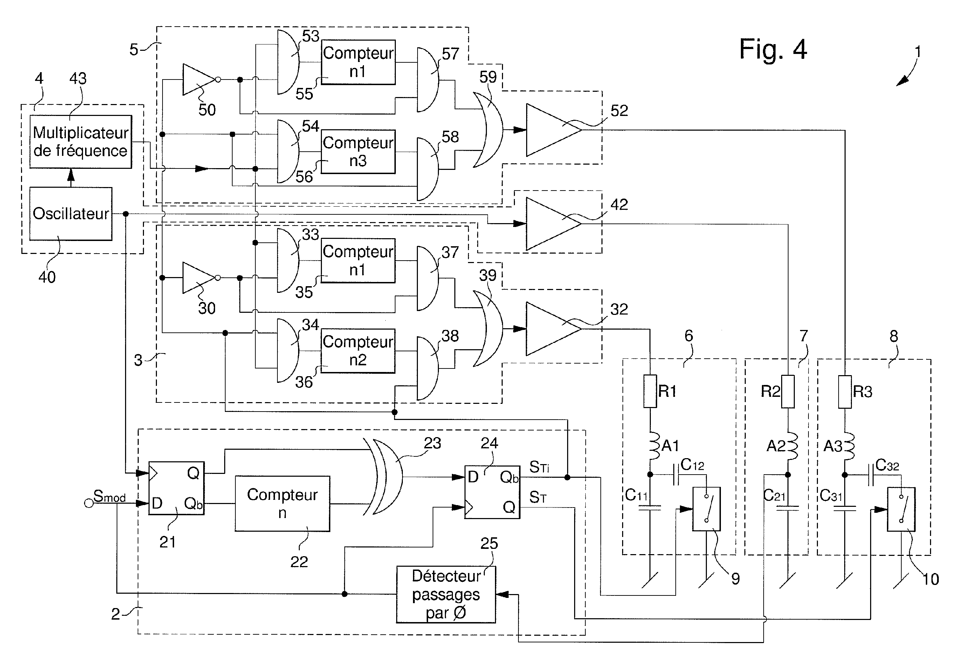

Le circuit de synchronisation 2, expliqué plus en détail ci-après en référence aux figures 3 et 4, est prévu pour gérer la commutation de manière synchrone des signaux fournis par les générateurs de signaux. Pour ce faire, la fréquence f1 doit être égale à f0·(n-0.5)/n, alors que la fréquence f3 doit être égale à f0·(n+0.5)/n, où n est un nombre entier définissant le nombre de cycles à la fréquence f0 pour chaque phase de transition d'état de modulation. Pour une fréquence porteuse f0 choisie à 128 kHz, le nombre n doit être égal à 8, ce qui donne une première fréquence f1 égale à 120 kHz et une troisième fréquence f3 égale à 136 kHz. Il peut également être défini que le rapport f0/Δf soit égal à N, qui est un nombre entier pair, où il est nécessaire de compter N/2 cycles à la fréquence f0 des signaux fournis par le second générateur de signaux 7 pour chaque phase de transition d'état de modulation.

Pour la génération d'un second état de modulation "0", les signaux transmis par les premier et troisième agencements d'antenne 6 et 8 doivent être déphasés de 180° en principe par rapport aux signaux transmis par le second agencement d'antenne 7. Par contre pour la génération d'un premier état de modulation "1", tous les signaux transmis par les agencements d'antenne 6, 7 et 8 sont en phase. De préférence, l'amplitude des signaux transmis par le premier agencement d'antenne 6 et le troisième agencement d'antenne 8 peut être adaptée pour être la moitié de l'amplitude des signaux transmis par le second agencement d'antenne 7. Ainsi avec un déphasage de 180° des signaux transmis par les premier et troisième agencements d'antenne 6 et 8 par rapport aux signaux transmis par le second agencement d'antenne 7, la combinaison ou addition des trois signaux transmis devient nulle après la phase de transition d'un premier état "1" au second état "0".

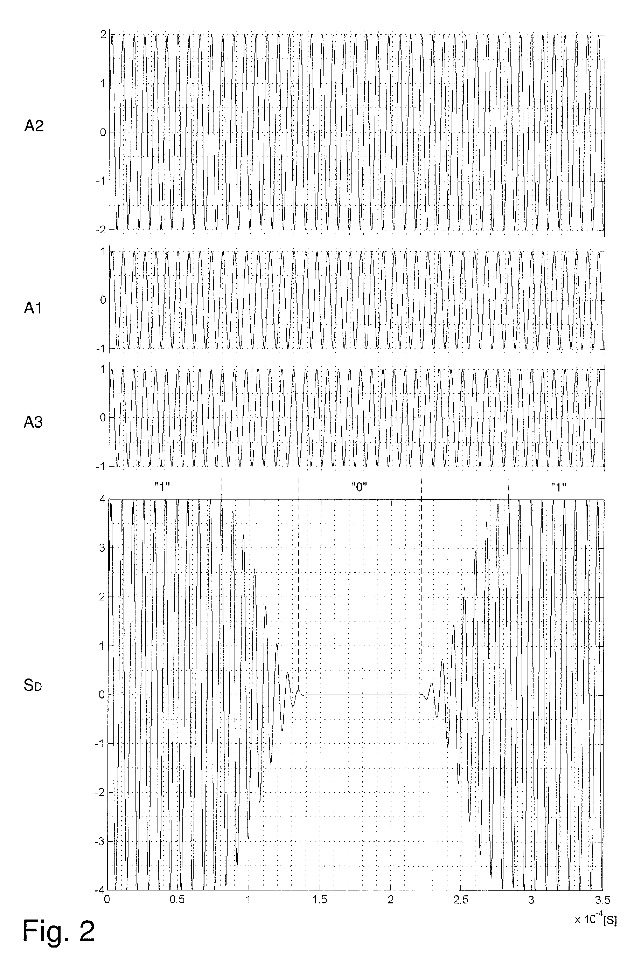

Sur la figure 2, il est représenté les signaux transmis par les antennes A1, A2, A3 des trois agencements d'antenne 6, 7, 8, qui sont normalement des signaux sinusoïdaux, ainsi que les signaux combinés S_{D}, dans lesquels la modulation en amplitude des données est opérée. On peut remarquer sur cette figure 2, que l'amplitude des signaux combinés de données S_{D} ont une amplitude maximale, lorsque les trois signaux transmis par les antennes sont en phase, alors que cette amplitude devient nulle, lorsque les signaux transmis par l'antenne 1 et l'antenne 3 sont déphasés de 180° des signaux transmis par l'antenne 2. Ainsi il est possible de définir un premier état de modulation "1" et un second état de modulation "0" par combinaison des trois signaux transmis par les antennes du dispositif d'émission. On peut également remarquer chaque phase de transition d'état de modulation notamment pour le passage d'un état "1" à un état "0" et pour le passage d'un état "0" à un état "1" après 8 cycles comptés des signaux de la seconde antenne.

Bien entendu, il peut également être envisagé d'utiliser uniquement deux antennes A1 et A2 pour pouvoir effectuer une modulation en amplitude des données. Dans ces conditions, uniquement deux générateurs de signaux reliés respectivement à deux agencements d'antenne sont nécessaires. De préférence, l'amplitude des signaux de chaque antenne peut être identique, ce qui permet de produire un état "1", lorsque les deux signaux transmis par les deux antennes sont en phase et un état "0", quand les deux signaux transmis par les deux antennes sont déphasés de 180°.

Il est encore à noter que l'amplitude des premier et troisième signaux des antennes A1 et A3 peut être différente de la moitié de l'amplitude des signaux de l'antenne A2. Cependant l'amplitude résultante de l'addition des premier et troisième signaux des antennes A1 et A3 doit toujours être égale ou inférieure à l'amplitude des signaux de l'antenne A2, même si l'amplitude des signaux de l'antenne A1 est aussi différente de l'amplitude des signaux de l'antenne A3.

En principe la détection des signaux combinés à modulation en amplitude de données S_{D}, comme représentés, sont captés convenablement par un dispositif récepteur, tel qu'un transpondeur à une distance d'au moins 2, 10 ou 15 m. Il est nécessaire que les antennes à boucles A1, A2, A3 utilisées pour le dispositif d'émission 1 de la figure 1, soient disposées de telle manière à être orientées dans la même direction avec leur axe parallèle l'un par rapport à l'autre. La dimension de chaque antenne dans le plan peut être identique et de 60 cm sur 60 cm ou de diamètre de l'ordre de 60 cm.

Chaque antenne à boucles, non représentée, peut comprendre 14 tours d'un enroulement de fil conducteur isolé de manière à obtenir une inductance de l'ordre de 370 pH. Un espacement entre chaque fil isolé peut être fixé à 1 mm. Le courant maximum traversant chaque antenne peut être de l'ordre d'au moins 1.2 A, voire jusqu'à 2.5 A avec une force de champ générée à 10 m de l'ordre de 66 dBµA/m. Le dispositif d'émission 1 peut être alimenté par une source de tension de 5 V.

Ces antennes peuvent se chevaucher en partie de telle manière que le couplage inductif entre les antennes A1 et A2, ainsi que le couplage inductif entre les antennes A2 et A3 soit minimal. Les antennes peuvent également être disposées l'une à côté de l'autre dans un même plan ou également être disposées l'une au-dessus de l'autre. Cependant la dimension de la zone occupée par les trois antennes A1, A2 et A3 doit être généralement bien inférieure à la longueur d'onde des signaux transmis par chaque antenne. Pour une fréquence porteuse f0 à 125 kHz par exemple, la longueur d'onde est de l'ordre de 2400 m. Pour des applications de transmission à champ proche, la zone occupée par les trois antennes A1, A2 et A3 doit être beaucoup plus petite que la distance de transmission ou la distance de mesure du champ magnétique/électrique, ce qui est défini dans les normes nationales et internationales.

Dans chaque état stable de modulation, la fréquence de résonance de chaque agencement d'antenne 6, 7 et 8 est bien déterminée en fonction des signaux fournis par chaque générateur de signaux 3, 4 et 5 à une fréquence porteuse f0. Cependant comme la fréquence des signaux est temporairement modifiée pour les premier et troisième agencements d'antenne 6 et 8, il doit encore être prévu d'adapter la fréquence de résonance dynamiquement lors de la phase de transition d'état de modulation pour chacun de ces agencements d'antenne 6 et 8. En adaptant dynamiquement et de manière synchrone par rapport à la phase des signaux à fréquence porteuse f0, la fréquence de résonance des premier et troisième agencements d'antenne 6 et 8, il est possible de réaliser chaque agencement d'antenne avec un haut facteur de qualité Q. Ce haut facteur de qualité Q peut être supérieur à 100 pour conserver en même temps une largeur de bande bien supérieure à 10%. Ceci permet de réduire les pertes de puissance notamment durant chaque phase de transition d'état de modulation et de n'avoir aucune réponse transitoire, si la commutation des antennes est effectuée de manière synchrone à un instant bien déterminé.

Dans chaque agencement d'antenne 6, 7 et 8, il peut être prévu des éléments inductifs ou capacitifs pouvant être combinés pour pouvoir adapter la fréquence de résonance de l'antenne en fonction de la fréquence des signaux fournis par chaque générateur de signaux 3, 4 et 5. En principe uniquement le premier agencement d'antenne 6 et le troisième agencement d'antenne 8 comprennent de tels éléments inductifs ou capacitifs complémentaires pour l'adaptation de la fréquence de résonance lors de chaque phase de transition d'état de modulation.

Le premier agencement d'antenne 6 peut comprendre en série entre la sortie du premier générateur de signaux 3 et une borne de masse, une résistance de perte R1, une inductance A1 définissant la première antenne et au moins un premier condensateur C₁₁. Un second condensateur C₁₂ peut être placé en parallèle du premier condensateur C₁₁ du premier agencement d'antenne par l'intermédiaire d'un premier interrupteur 9 pour adapter la fréquence de résonance. Ce premier interrupteur est commandé de manière synchrone par un premier signal de commande S_{Ti} du circuit de synchronisation 2. Ce premier interrupteur peut être composé traditionnellement d'un transistor MOS, tel qu'un transistor NMOS, dont les bornes de source et drain sont reliées entre une borne du second condensateur C₁₂ et la borne de masse. La borne de grille de ce transistor NMOS est prévue pour recevoir le premier signal de commande S_{Ti}. Si ce premier signal de commande S_{Ti} est à l'état haut, le transistor NMOS est rendu conducteur et le second condensateur C₁₂ est placé en parallèle du premier condensateur C₁₁. Par contre si ce premier signal de commande S_{Ti} est à l'état bas par exemple à 0 V, le transistor NMOS est non conducteur et uniquement le premier condensateur C₁₁ est branché en série avec l'inductance A1 et la résistance de perte R1.

Le second agencement d'antenne 7 peut ne comprendre qu'en série entre la sortie du second générateur de signaux 4 et une borne de masse, une résistance de perte R2, une inductance A2 définissant la seconde antenne et au moins un condensateur C₂₁. Il n'est pas nécessaire pour ce second agencement d'antenne 7 d'adapter la fréquence de résonance lors de la phase de transition d'état de modulation. Les éléments, qui composent ce second agencement d'antenne 7 sont déterminés initialement de telle manière que la fréquence de résonance corresponde à la fréquence porteuse f0 des signaux fournis par le second générateur de signaux 4.

Le troisième agencement d'antenne 8 peut comprendre en série entre la sortie du troisième générateur de signaux 5 et une borne de masse, une résistance de perte R3, une inductance A3 définissant la première antenne et au moins un premier condensateur C₃₁. Un second condensateur C₃₂ peut être placé en parallèle du premier condensateur C₃₁ du troisième agencement d'antenne par l'intermédiaire d'un second interrupteur 10 pour adapter la fréquence de résonance. Ce second interrupteur est commandé de manière synchrone par un second signal de commande S_{T}, qui est l'inverse du premier signal de commande S_{Ti}. Le second signal de commande est fourni par le circuit de synchronisation 2. Ce second interrupteur 10 peut être composé comme le premier interrupteur 9, d'un transistor MOS, tel qu'un transistor NMOS, dont les bornes de source et drain sont reliées entre une borne du second condensateur C₃₂ du troisième agencement d'antenne 8 et la borne de masse. La borne de grille de ce transistor NMOS est prévue pour recevoir le second signal de commande S_{T}. Si ce second signal de commande S_{T} est à l'état haut, le transistor NMOS est rendu conducteur et le second condensateur C₃₂ est placé en parallèle du premier condensateur C₃₁. Par contre si ce second signal de commande S_{T} est à l'état bas par exemple à 0 V, le transistor NMOS est non conducteur et uniquement le premier condensateur C₃₁ est branché en série avec l'inductance A3 et la résistance de perte R3.

A titre d'exemple numérique, les résistances de perte R1, R2 et R3 peuvent être fixées chacune à une valeur résistive égale à 3 Ohms. Chaque inductance A1, A2 et A3 peut être d'une valeur de 370 µH. Le premier condensateur C₁₁ du premier agencement d'antenne 6 peut être d'une valeur capacitive égale à 4.183 nF, tout comme le condensateur C₂₁ du second agencement d'antenne 7. Le second condensateur C₁₂ du premier agencement d'antenne 6 peut être d'une valeur capacitive égale à 576 pF. Le premier condensateur C₃₁ du troisième agencement d'antenne 8 peut être d'une valeur capacitive égale à 3.705 nF, et le second condensateur C₃₂ du troisième agencement d'antenne 8 peut être d'une valeur capacitive égale à 478 pF. Ces valeurs numériques sont définies pour un fonctionnement du dispositif d'émission 1 avec des signaux transmis à une fréquence porteuse f0 égale à 128 kHz, et pour des fréquences modifiées temporairement des premier et troisième agencements d'antenne 6 et 8 égales à 120 kHz et 136 kHz. Pour les fréquences modifiées, le premier interrupteur 9 est temporairement fermé pour avoir une valeur capacitive de 4.759 nF avec le premier condensateur C₁₁ mis en parallèle avec le second condensateur C₁₂, alors que le second interrupteur 10 est ouvert avec une valeur capacitive du premier condensateur C₃₁ à 3.705 nF.

Lorsque chaque état de modulation est bien établi après chaque phase de transition d'état de modulation, les signaux transmis par les trois antennes A1, A2 et A3 sont à une fréquence porteuse f0, qui peut être égale à 128 kHz. Dans chaque état stable de modulation, le premier interrupteur 9 est toujours ouvert par le premier signal de commande S_{Ti} fourni par le circuit de synchronisation 2, alors que le second interrupteur 10 est toujours fermé, car commandé par le second signal de commande S_{T}. Par contre pendant la phase de transition d'état de modulation, le premier interrupteur 9 est temporairement fermé, alors que le second interrupteur 10 est temporairement ouvert. Pour pouvoir commuter les fréquences des signaux fournis par les premier et troisième générateurs de signaux 3 et 5, il est nécessaire d'opérer cette commutation de manière synchrone et à l'instant approprié par rapport à la phase des signaux à fréquence porteuse f0 pour éviter toute réponse transitoire.

La phase de transition d'état de modulation peut durer 8 cycles des signaux sinusoïdaux du second agencement d'antenne 7. En adaptant la fréquence de résonance des premier et troisième agencements d'antenne 6 et 8, il est nécessaire d'opérer chaque commutation de fréquence des signaux fournis par les premier et troisième générateurs de signaux 3 et 5 en détectant les passages par zéro des signaux sinusoïdaux du second agencement d'antenne. Pour ce faire, le noeud de connexion entre l'inductance A2 et le condensateur C₂₁ du second agencement d'antenne 7 est relié au circuit de synchronisation 2, qui comprend un détecteur de passages par zéro de la tension. L'adaptation de fréquence de résonance doit intervenir au moment où la tension sur le condensateur C₂₁ du second agencement d'antenne 7 se trouve à 0 V sans énergie électrique stockée pour éviter toute réponse transitoire. Au même moment, la tension au début et à la fin de chaque phase de transition sur chacun des condensateurs C₁₁ et C₃₁ doit être nécessairement à 0 V.

Chaque passage par zéro détecté par le détecteur peut être compté par un compteur dans le circuit de synchronisation de manière à commander la fermeture ou l'ouverture des premier et second interrupteurs 9 et 10. De même, le premier signal de commande S_{Ti} peut être utilisé pour commander la commutation de fréquence des premier et troisième générateurs de signaux 3 et 5. La commutation de fréquence des agencements d'antenne 6 et 8 intervient également à un passage par zéro des signaux transmis par la première antenne A1 et la troisième antenne A3. Cependant la commutation de fréquence intervient une fois avec un déphasage de 180° par rapport aux signaux du second agencement d'antenne 7 pour le second état de modulation, et en phase pour le premier état de modulation. Ainsi chaque transition d'état de modulation est opérée de manière synchrone avec une modification dynamique de chaque fréquence de résonance des agencements d'antenne. Cela permet d'opérer une transition continue et adoucie sans perte d'énergie par un passage du type à décrochage cosinus ou cosinus surélevé d'un état à un autre état de modulation. Par contre avec deux antennes, la transition d'état de modulation sur les signaux à modulation du type OOK ne peut pas être faite en forme de cosinus, mais avec un changement, qui introduit un pli dans les signaux de modulation transmis. Ceci apporte un très mauvais comportement au niveau de l'efficacité spectrale.

A la figure 3, il est représenté une première forme d'exécution un peu plus détaillée du dispositif d'émission 1. Il est à noter que les éléments de cette figure 3, qui correspondent à ceux de la figure 1, portent des signes de référence identiques. De ce fait par simplification, il ne sera pas répété la description de tous ces éléments. L'adaptation de fréquence de résonance des premier et troisième agencements d'antenne 6 et 8 est effectuée de manière capacitive comme pour la forme générale présentée à la figure 1. Pour ce faire, un second condensateur complémentaire C₁₂, C₃₂ peut être placé en parallèle d'un premier condensateur C₁₁, C₃₁ par l'intermédiaire d'un premier interrupteur 9 ou d'un second interrupteur 10 commandé inversement.

Le second générateur de signaux 4 comprend de préférence un oscillateur 40 susceptible de générer un signal oscillant à une fréquence, qui peut être choisie supérieure au MHz, par exemple à 32.64 MHz. Le signal oscillant peut être de forme sinusoïdale, mais de préférence composé d'impulsions de forme rectangulaire. La fréquence du signal oscillant est divisée dans un diviseur de fréquence 41, qui fournit ainsi un signal à fréquence divisée à un circuit d'entraînement 42. Sur la base du signal à fréquence divisée, le circuit d'entraînement 42 fournit des signaux à fréquence déterminée au second agencement d'antenne 7. La fréquence déterminée peut être une fréquence porteuse f0 égale par exemple à 128 kHz. Dans ces conditions, le diviseur de fréquence 41 doit diviser le signal oscillant par un facteur égal à 255.

Il est à noter que le circuit d'entraînement 42 a également pour tâche d'adapter l'amplitude des signaux transmis par l'antenne A2 du second agencement d'antenne 7. Pour ce faire, le circuit d'entraînement 42 peut être contrôlé par une unité de traitement à microprocesseur non représentée. Ce circuit d'entraînement 42 peut être composé d'un amplificateur non linéaire ou peut comprendre également un modulateur de largeur d'impulsions bien connu. Ce modulateur de largeur d'impulsions est commandé par l'unité de traitement à microprocesseur sur la base d'une mesure d'une tension ou d'un courant effectuée en sortie du circuit d'entraînement 42, jusqu'à obtenir l'amplitude souhaitée des signaux transmis par l'antenne A2.

Le premier générateur de signaux 3 est composé d'un diviseur de fréquence programmable 31 suivi d'un circuit d'entraînement 32, qui fournit les signaux à fréquence adaptée au premier agencement d'antenne 6. Le diviseur de fréquence reçoit le signal oscillant d'un oscillateur 40 du second générateur de signaux 4. Sur la base de ce signal oscillant, le diviseur de fréquence 31 divise la fréquence du signal oscillant par le facteur 255, lorsqu'un état stable de modulation de données est défini ou lorsqu'aucune modulation de données n'est effectuée. Par contre lors d'une phase de transition d'état de modulation pour le passage d'un état "1" à un état "0", ou inversement, la fréquence du signal oscillant est divisée par le facteur 272. De cette manière, le circuit d'entraînement 32 fournit des signaux à une fréquence temporairement égale à 120 kHz au premier agencement d'antenne 6. Le premier signal de commande S_{Ti}, fourni par le circuit de synchronisation 2, peut être utilisé pour commander le changement du facteur de division du diviseur de fréquence 31.

Le troisième générateur de signaux 5 est composé d'un diviseur de fréquence programmable 51 suivi d'un circuit d'entraînement 52, qui fournit les signaux à fréquence adaptée au troisième agencement d'antenne 8. Le diviseur de fréquence reçoit le signal oscillant de l'oscillateur 40 du second générateur de signaux 4. Sur la base de ce signal oscillant, le diviseur de fréquence 51 divise la fréquence du signal oscillant par le facteur 255, lorsqu'un état stable de modulation de données est défini ou lorsqu'aucune modulation de données n'est effectuée. Par contre lors d'une phase de transition d'état de modulation pour le passage d'un état "1" à un état "0", ou inversement, la fréquence du signal oscillant est divisée par le facteur 240. De cette manière, le circuit d'entraînement 52 fournit des signaux à une fréquence temporairement égale à 136 kHz au troisième agencement d'antenne 8. Le premier signal de commande S_{Ti}, fourni par le circuit de synchronisation 2, peut être également utilisé pour commander le changement du facteur de division du diviseur de fréquence 51.

Il est à noter que le facteur de division de chaque diviseur de fréquence 31, 41, 51 peut être déterminé en fonction de la fréquence porteuse f0 souhaitée et de l'écart de fréquence Δf. Pour un facteur de division égal à N, qui est un nombre entier, les signaux divisés en sortie des diviseurs de fréquence sont à une fréquence porteuse f0 déterminée en fonction de la fréquence du signal oscillant de l'oscillateur. Pour les signaux à fréquence f0-Δf pour le premier agencement d'antenne 6, le facteur de division du diviseur de fréquence 31 est égal à N·(1+Δf/f0). Pour les signaux à fréquence f0+Δf pour le troisième agencement d'antenne 6, le facteur de division du diviseur de fréquence 51 est égal à N·(1-Δf/f0).

Les circuits d'entraînement 32 et 52 des premier et troisième générateurs de signaux 3 et 5, peuvent être également contrôlés par l'unité de traitement à microprocesseur pour adapter l'amplitude des signaux transmis par les premier et troisième agencements d'antenne 6 et 8. L'amplitude des signaux des premier et troisième agencements d'antenne 6 et 8 peut être adaptée pour être la moitié de l'amplitude des signaux du second agencement d'antenne 7.

Le circuit de synchronisation 2 comprend une première bascule du type D 21 pour recevoir en entrée le signal de modulation S_{mod}, qui peut être composé d'impulsions de forme rectangulaire représentant les données ou au moins une commande à transmettre. La sortie non inversée Q de la première bascule 21 est reliée à une première entrée d'une porte du type OU-Exclusif 23, alors que la sortie inversée Qb de la première bascule est reliée à l'entrée d'un compteur par n 22, où n est un nombre entier supérieur à 1. La sortie de ce compteur 22 est reliée à une seconde entrée de la porte du type OU-Exclusif 23. La sortie de cette porte du type OU-Exclusif 23 est reliée à l'entrée d'une seconde bascule du type D 24, qui est susceptible de fournir notamment le premier signal de commande S_{T}; à une sortie inversée Qb et le second signal de commande S_{T} à une sortie non inversée Q. Ces signaux de commande S_{T} et S_{Ti} sont ainsi utilisés en partie pour contrôler l'ouverture ou la fermeture des interrupteurs 9 et 10 des agencements d'antenne 6 et 8.

Les première et seconde bascules du type D 21 et 24 sont cadencées par un signal de cadencement provenant d'un détecteur de passages par zéro 25. Ce détecteur de passages par zéro 25 détecte les passages par zéro de la tension sinusoïdale au niveau du noeud de connexion entre l'inductance A2 et le condensateur C₂₁ du second agencement d'antenne 7. Cette tension sinusoïdale représente la forme des signaux transmis du second agencement d'antenne 7. La tension sinusoïdale est ainsi transformée à travers le détecteur de passages par zéro 25 en un signal de cadencement composé d'impulsions rectangulaires successives à une même fréquence f0 que la tension sinusoïdale.

Le compteur par n 22 est normalement aussi cadencé sur la base des flancs montants des impulsions de cadencement fournies par le détecteur de passages par zéro 25. Lors d'un changement d'état en sortie inversée Qb de la première bascule 21, le nouvel état de la sortie Qb n'est transmis en sortie du compteur 22 qu'après n impulsions de cadencement fournies par le détecteur de passages par zéro 25. Ces n impulsions correspondent au nombre n de cycles de la tension sinusoïdale sur le condensateur C₂₁ ou des signaux transmis par l'antenne A2 du second agencement d'antenne 7. Pendant une durée correspondant à n impulsions de cadencement, la porte OU-Exclusif ne fournit qu'un état "0" à l'entrée de la seconde bascule 24. Le premier signal de commande S_{Ti} à la sortie inversée Qb de la seconde bascule 24 est donc à un niveau haut "1" pendant la durée correspondant aux n impulsions de cadencement, qui correspondent à la phase de transition d'état de modulation. Pendant cette phase de transition d'état de modulation, les fréquences de résonance du premier agencement d'antenne 6 et du troisième agencement d'antenne 8 sont adaptées en fonction des fréquences modifiées des signaux fournis par les premier et troisième générateurs de signaux 3 et 5.

A la figure 4, il est représenté une seconde forme d'exécution un peu plus détaillée du dispositif d'émission 1. Il est à noter que les éléments de cette figure 4, qui correspondent à ceux des figures 1 et 3, portent des signes de référence identiques. De ce fait par simplification, il ne sera pas répété la description de tous ces éléments. L'adaptation de fréquence de résonance des premier et troisième agencements d'antenne 6 et 8 est effectuée de manière capacitive comme pour la forme générale présentée à la figure 1 et la première forme d'exécution présentée à la figure 3.

Le second générateur de signaux 4 comprend de préférence un oscillateur 40 susceptible de générer un signal oscillant à une fréquence, qui correspond à la fréquence porteuse des signaux à transmettre par le second agencement d'antenne 7. La fréquence du signal oscillant peut donc être choisie par exemple à 128 kHz, comme la fréquence porteuse f0 des signaux à transmettre par le second agencement d'antenne 7. Le signal oscillant peut être de forme sinusoïdale, mais de préférence composé d'impulsions de forme rectangulaire fournies directement au circuit d'entraînement 42. Le circuit d'entraînement 42 fournit donc les signaux à fréquence porteuse f0 au second agencement d'antenne 7.

Le second générateur de signaux 4 comprend encore un multiplicateur de fréquence 43 relié directement à l'oscillateur 40. Ce multiplicateur de fréquence est utilisé pour multiplier la fréquence du signal oscillant par un facteur n1, qui est un nombre entier supérieur à 1. Le signal à fréquence multipliée dans le multiplicateur de fréquence 43 est fourni aux premier et troisième générateurs de signaux 3 et 5. Pour une fréquence porteuse f0 des signaux à transmettre par l'antenne A2, choisie à 128 kHz, le facteur de multiplication n1 peut être choisi égal à 255.

Le premier générateur de signaux 3 comprend des première et seconde branches de division de la fréquence du signal à fréquence multipliée reçu du multiplicateur de fréquence 43. Dans la première branche de division, la fréquence est divisée par le facteur n1 de manière à fournir en sortie du premier générateur de signaux 3, des signaux à la fréquence porteuse f0. Dans la seconde branche de division, la fréquence est divisée par un facteur n2, qui est un nombre entier supérieur à 1. Ce facteur n2 est choisi pour que le premier générateur de signaux fournisse temporairement des signaux au premier agencement d'antenne 6, à une fréquence f1=f0-Δf, pendant la phase de transition d'état de modulation. La fréquence f1 est donc déterminée par f0·n1/n2. Pour obtenir la fréquence f1 égale à 120 kHz par exemple, le facteur n2 doit être égal à 272.

Le premier générateur de signaux 3 comprend donc pour la première branche de division, un premier inverseur 30, qui reçoit le premier signal de commande S_{Ti} provenant du circuit de synchronisation 2. Ce premier signal de commande S_{Ti} est à l'état "1" pendant la phase de transition d'état de modulation et à l'état "0" pour chaque état stable de modulation avant et après la phase de transition. La première branche est donc utilisée, quand le premier signal de commande S_{Ti} est à l'état "0", alors que la seconde branche est utilisée, quand le premier signal de commande S_{Ti} est à l'état "1".

La sortie du premier inverseur 30 de la première branche est reliée à une première entrée d'une première porte ET 33, qui reçoit à une seconde entrée le signal à fréquence multipliée du multiplicateur de fréquence 43. Le signal à fréquence multipliée est transmis à un premier compteur par n1 35, si la sortie du premier inverseur 30 est à l'état "1 ". Ceci permet de diviser la fréquence du signal à fréquence multipliée par le facteur n1. La sortie du premier compteur 35 est reliée à une seconde porte ET 37, qui reçoit à une seconde entrée le signal de sortie du premier inverseur 30. La sortie de la seconde porte ET 37 est reliée à une première entrée d'une porte OU 39 pour fournir le signal à fréquence porteuse f0 au circuit d'entraînement 32. Ce circuit d'entraînement 32 est de configuration similaire à celui de la figure 3 de manière à fournir des signaux à fréquence porteuse f0 au premier agencement d'antenne 6, en dehors de la phase de transition d'état de modulation.

Pour la seconde branche de division, le premier signal de commande S_{Ti} est fourni directement à une première entrée d'une troisième porte ET 34, alors que la seconde entrée de la porte ET 34 reçoit le signal à fréquence multipliée du multiplicateur de fréquence 43. Le signal à fréquence multipliée est transmis à un second compteur par n2 36, si le premier signal de commande S_{Ti} est à l'état "1 ". Ceci permet de diviser la fréquence du signal à fréquence multipliée par le facteur n2. La sortie du second compteur 36 est reliée à une quatrième porte ET 38, qui reçoit à une seconde entrée le premier signal de commande S_{Ti}. La sortie de la quatrième porte ET 38 est reliée à une seconde entrée de la porte OU 39 pour fournir le signal à fréquence adaptée f1=f0-Δf au circuit d'entraînement 32. Cette fréquence adaptée f1 peut donc être égale à 120 kHz pour cette forme d'exécution du dispositif d'émission 1.

Le troisième générateur de signaux 5 comprend également des première et seconde branches de division de la fréquence du signal à fréquence multipliée reçu du multiplicateur de fréquence 43. Dans la première branche de division, la fréquence est divisée par le facteur n1 pour fournir en sortie du troisième générateur de signaux 5, des signaux à la fréquence porteuse f0 au troisième agencement d'antenne 8. Dans la seconde branche de division, la fréquence est divisée par un facteur n3, qui est un nombre entier supérieur à 1. Ce facteur n3 est choisi pour que le troisième générateur de signaux fournisse temporairement des signaux au troisième agencement d'antenne 8, à une fréquence f3=f0+Δf, pendant la phase de transition d'état de modulation. La fréquence f3 est donc déterminée par f0·n1/n3. Pour obtenir la fréquence f3 égale à 136 kHz par exemple, le facteur n3 doit être égal à 240.

Le troisième générateur de signaux 5 comprend donc pour la première branche de division, un second inverseur 50, qui reçoit le premier signal de commande S_{Ti} provenant du circuit de synchronisation 2. Ce premier signal de commande S_{Ti} est à l'état "1" pendant la phase de transition d'état de modulation et à l'état "0" pour chaque état stable de modulation avant et après la phase de transition. La première branche est utilisée, quand le premier signal de commande S_{Ti} est à l'état "0", alors que la seconde branche est utilisée, quand le premier signal de commande S_{Ti} est à l'état "1".

La sortie du second inverseur 50 de la première branche est reliée à une première entrée d'une première porte ET 53, qui reçoit à une seconde entrée le signal à fréquence multipliée du multiplicateur de fréquence 43. Le signal à fréquence multipliée est transmis à un premier compteur par n1 55, si la sortie du second inverseur 50 est à l'état "1 ". Ceci permet de diviser la fréquence du signal à fréquence multipliée par le facteur n1. La sortie du premier compteur 55 est reliée à une seconde porte ET 57, qui reçoit à une seconde entrée le signal de sortie du second inverseur 50. La sortie de la seconde porte ET 57 est reliée à une première entrée d'une porte OU 59 pour fournir le signal à fréquence porteuse f0 au circuit d'entraînement 52. Ce circuit d'entraînement 52 est de configuration similaire à celui de la figure 3 de manière à fournir des signaux à fréquence porteuse f0 au troisième agencement d'antenne 8, en dehors de la phase de transition d'état de modulation.

Pour la seconde branche de division, le premier signal de commande S_{Ti} est fourni directement à une première entrée d'une troisième porte ET 54, alors que la seconde entrée de la porte ET 54 reçoit le signal à fréquence multipliée du multiplicateur de fréquence 43. Le signal à fréquence multipliée est transmis à un second compteur par n3 56, si le premier signal de commande S_{Ti} est à l'état "1 ". Ceci permet de diviser la fréquence du signal à fréquence multipliée par le facteur n3. La sortie du second compteur 56 est reliée à une quatrième porte ET 58, qui reçoit à une seconde entrée le premier signal de commande S_{Ti}. La sortie de la quatrième porte ET 58 est reliée à une seconde entrée de la porte OU 59 pour fournir le signal à fréquence adaptée f3=f0+Δf au circuit d'entraînement 52. Cette fréquence adaptée f3 peut donc être égale à 136 kHz pour cette forme d'exécution du dispositif d'émission 1.

Il est à noter que le circuit de synchronisation 2 comprend les mêmes éléments décrits ci-devant en référence à la figure 3. Cependant la première bascule 21 peut être cadencée directement par le signal oscillant de l'oscillateur 40, alors que la seconde bascule 24 reste cadencée par le signal à impulsions rectangulaires fourni par le détecteur de passages par zéro 25.

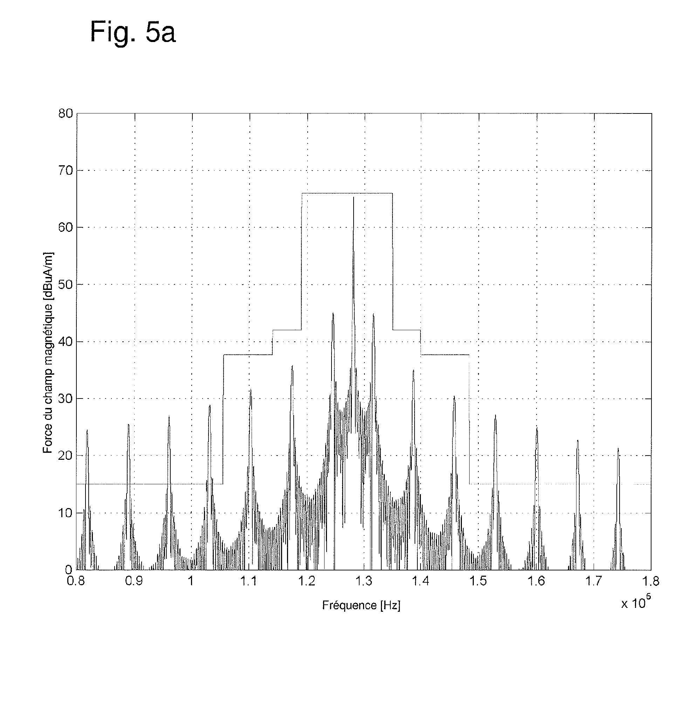

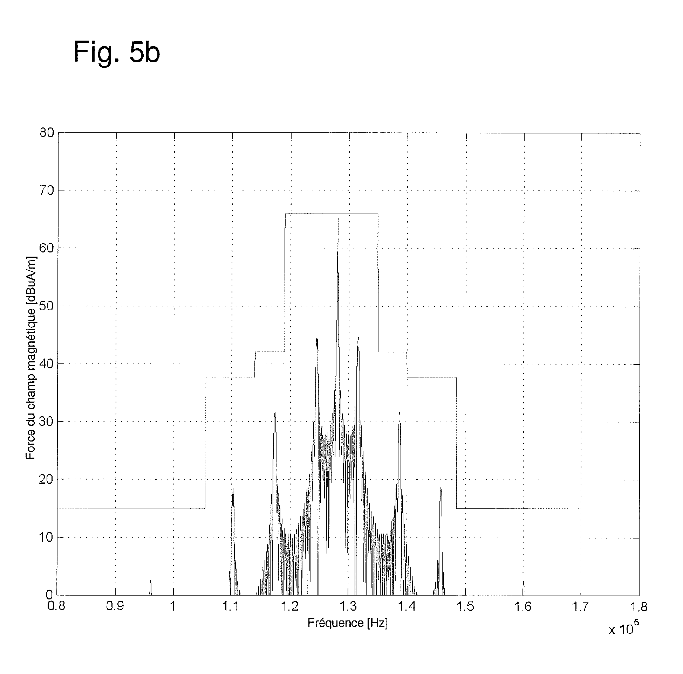

Les figures 5a et 5b représentent deux graphiques comparatifs du spectre de la modulation d'amplitude des données dans les signaux transmis par une seule antenne, et par des agencements d'antenne selon la présente invention. On remarque qu'avec le dispositif d'émission de la présente invention et du principe alternatif de l'ensemble des antennes, les fréquences harmoniques par rapport à la fréquence centrale, qui est dans ce cas à 128 kHz sont fortement réduites. La force du champ magnétique du principe d'émission au moyen des trois agencements d'antenne de l'invention permet de se trouver dans le masque du spectre des requêtes régulatoires en fonction du domaine d'application, tel que le domaine du sport. Avec la transmission de signaux à modulation d'amplitude au moyen d'une seule antenne, de nombreuses harmoniques surviennent qui se trouvent en dehors du masque de spectre requis.

A partir de la description qui vient d'être faite, plusieurs variantes du dispositif d'émission de signaux de données et/ou de commande, ainsi que le procédé de mise en action du dispositif d'émission, peuvent être conçues par l'homme du métier sans sortir du cadre de l'invention définie par les revendications. Il peut être prévu d'utiliser six agencements d'antenne contrôlés respectivement par six générateurs de signaux. Trois premiers agencements d'antenne peuvent transmettre des signaux de données et/ou de commande comme décrit ci-devant, et trois seconds agencements d'antenne de même configuration que les trois premiers agencements d'antenne, transmettent des signaux avec un déphasage de 90°. Dans le cas d'une adaptation de la fréquence de résonance au moyen d'une inductance complémentaire, il peut être utilisé un détecteur de pics ou passages par maxima et minima pour commander le circuit de synchronisation. Chaque commutation de fréquence dans chaque phase de transition d'état de modulation doit se faire, lorsque le courant dans l'inductance du second agencement d'antenne est égal à 0 A, ainsi que dans les inductances adaptées des autres agencements d'antenne.

## Revendications

1. Dispositif (1) d'émission de signaux de données et/ou de commande, le dispositif comprenant :
- un premier générateur de signaux (3) relié à un premier agencement d'antenne (6),
- un second générateur de signaux (4) relié à un second agencement d'antenne (7),
- un oscillateur (40) pour fournir un signal oscillant, afin de cadencer les générateurs de signaux pour commander chaque agencement d'antenne, et
- un circuit de synchronisation (2) relié au moins au premier générateur de signaux (3) et aux premier et second agencements d'antenne (6, 7), le circuit de synchronisation (2) étant prévu pour recevoir en entrée un signal de modulation (S_{mod}) des données et/ou de commande et pour contrôler de manière synchrone le premier générateur de signaux (3) et les premier et second agencements d'antenne (6, 7) pour opérer une modulation en amplitude des données et/ou de commande à transmettre à deux niveaux d'amplitude par combinaison des signaux transmis par les agencements d'antenne, un premier état stable de modulation à un premier niveau d'amplitude étant défini, quand les signaux transmis à une fréquence porteuse définie f0 par les premier et second agencements d'antenne sont en phase, et un second état stable de modulation à un second niveau d'amplitude étant défini, quand les signaux transmis à une fréquence porteuse définie f0 par le premier agencement d'antenne (6) sont déphasés de 180° des signaux transmis à une fréquence porteuse définie f0 par le second agencement d'antenne (7),
**caractérisé en ce que** le circuit de synchronisation (2) est agencé pour commuter temporairement et dynamiquement le premier générateur de signaux (3) pour la fourniture de signaux au premier agencement d'antenne (6) à une fréquence f1 supérieure ou inférieure à la fréquence porteuse f0 dans une phase de transition d'un premier état de modulation à un second état de modulation ou inversement de manière synchrone sur la base de n cycles des signaux à la fréquence porteuse f0 transmis par le second agencement d'antenne (7) et comptés dans le circuit de synchronisation (2), où n est un nombre entier, et
**en ce que** le circuit de synchronisation (2) est agencé pour adapter de manière inductive ou capacitive la fréquence de résonance du premier agencement d'antenne (6) à la fréquence f1 des signaux fournis par le premier générateur de signaux (3) durant la phase de transition d'état de modulation par rapport à la fréquence de résonance déterminée à la fréquence porteuse f0 des premier et second agencements d'antenne dans un état stable de modulation.

2. Dispositif (1) d'émission de signaux de données et/ou de commande, selon la revendication 1, **caractérisé en ce qu'il** comprend un troisième générateur de signaux (5) relié à un troisième agencement d'antenne (8), qui sont contrôlés de manière synchrone par le circuit de synchronisation (2), pour opérer une modulation en amplitude des données et/ou de commande à transmettre par combinaison des signaux transmis par les premier, second et troisième agencements d'antenne (6, 7, 8), un premier état stable de modulation étant défini, quand les signaux transmis à une fréquence porteuse définie f0 par les premier, second et troisième agencements d'antenne (6, 7, 8) sont en phase, alors qu'un second état stable de modulation étant défini, quand les signaux transmis par les premier et troisième agencements d'antenne sont déphasés de 180° des signaux transmis par le second agencement d'antenne,
**en ce que** le circuit de synchronisation (2) est agencé pour commuter temporairement et dynamiquement durant chaque phase de transition d'état de modulation, le troisième générateur de signaux (5) pour la fourniture de signaux au troisième agencement d'antenne (8) à une fréquence f3 = f0+Δf, alors que les signaux fournis temporairement par le premier générateur de signaux (3) au premier agencement d'antenne sont à une fréquence f1 = f0-Δf, où Δf définit un écart de fréquence déterminé de telle manière que (f0/Δf)/2 définit le nombre n de cycles des signaux à la fréquence porteuse f0 transmis par le second agencement d'antenne (7), et
**en ce que** le circuit de synchronisation est agencé pour adapter de manière inductive ou capacitive la fréquence de résonance du troisième agencement d'antenne (8) à la fréquence f3 des signaux fournis par le troisième générateur de signaux (3) durant la phase de transition d'état de modulation.

3. Dispositif (1) d'émission de signaux de données et/ou de commande, selon la revendication 2, **caractérisé en ce que** le circuit de synchronisation est agencé pour adapter de manière inductive ou capacitive la fréquence de résonance des premier et troisième agencements d'antenne (6, 8) à la fréquence f1 et à la fréquence f3 à un instant où un courant est à 0 A pour un élément inductif ou une tension est à 0 V pour un élément capacitif.

4. Dispositif (1) d'émission de signaux de données et/ou de commande, selon la revendication 2, **caractérisé en ce que** les signaux transmis par le premier agencement d'antenne (6) sont à une fréquence f1 = f0·(n-0.5)/n durant la phase de transition d'état de modulation, alors que les signaux transmis par le troisième agencement d'antenne (8) sont à une fréquence f3 = f0·(n+0.5)/n.

5. Dispositif (1) d'émission de signaux de données et/ou de commande, selon la revendication 2, **caractérisé en ce que** les premier, second et troisième agencements d'antenne (6, 7, 8) comprennent chacun en série entre la sortie des premier, second et troisième générateurs de signaux (3, 4, 5) et une borne de masse, une résistance de perte (R1, R2, R3), une inductance (A1, A2, A3) définissant une antenne et au moins un premier condensateur (C₁₁, C₂₁, C₃₁), **en ce que** le premier agencement d'antenne (6) comprend encore un second condensateur (C₁₂) pouvant être placé en parallèle du premier condensateur (C₁₁) du premier agencement d'antenne par l'intermédiaire d'un premier interrupteur (9) commandé par un premier signal de commande (S_{Ti}) du circuit de synchronisation (2) pour adapter la fréquence de résonance, et **en ce que** troisième agencement d'antenne (8) comprend encore un second condensateur (C₃₂) pouvant être placé en parallèle du premier condensateur (C₃₁) du troisième agencement d'antenne par l'intermédiaire d'un second interrupteur (10) commandé par un second signal de commande (S_{T}) du circuit de synchronisation (2) pour adapter la fréquence de résonance.

6. Dispositif (1) d'émission de signaux de données et/ou de commande, selon la revendication 5, **caractérisé en ce que** le premier signal de commande (S_{Ti}) est l'inverse du second signal de commande (S_{T}), et **en ce que** le premier signal de commande est agencé pour fermer le premier interrupteur dans la phase de transition d'état de modulation, alors que second signal de commande est agencé pour ouvrir le second interrupteur (10) dans la phase de transition d'état de modulation.

7. Dispositif (1) d'émission de signaux de données et/ou de commande, selon la revendication 5, **caractérisé en ce que** les antennes (A1, A2, A3) des premier, second et troisième agencements d'antenne (6, 7, 8) sont disposées de telle manière à être orientées dans la même direction avec leur axe parallèle l'un par rapport à l'autre, la dimension de la zone occupée par les trois antennes (A1, A2, A3) étant inférieure à la longueur d'onde des signaux transmis par les antennes.

8. Dispositif (1) d'émission de signaux de données et/ou de commande, selon la revendication 5, **caractérisé en ce que** le circuit de synchronisation (2) comprend un détecteur de passages par zéro (25) relié à un noeud de connexion entre l'antenne (A2) et le premier condensateur (C₂₁) du second agencement d'antenne (7), pour détecter les passages par zéro de la tension sinusoïdale générée sur le premier condensateur, afin de synchroniser la fourniture des premier et second signaux de commande (S_{Ti}, S_{T}) aux premier et troisième agencements d'antenne (6, 8) pour l'adaptation de la fréquence de résonance.

9. Dispositif (1) d'émission de signaux de données et/ou de commande, selon la revendication 8, **caractérisé en ce que** le circuit de synchronisation (2) comprend une première bascule du type D (21) pour recevoir en entrée un signal de modulation (S_{mod}) dépendant des données et/ou de commande à transmettre, une sortie non inversée de la première bascule (21) étant reliée à une première entrée d'une porte du type OU-Exclusif (23), alors qu'une sortie inversée de la première bascule (21) est reliée à une entrée d'un compteur par n (22), où n est un nombre entier supérieur à 1 définissant le nombre de cycles à compter des signaux à la fréquence porteuse f0 transmis par le second agencement d'antenne (7), une sortie de ce compteur (22) étant reliée à une seconde entrée de la porte du type OU-Exclusif (23), une sortie de la porte du type OU-Exclusif (23) étant reliée à une entrée d'une seconde bascule du type D (24), la seconde bascule (24) fournissant à une sortie inversée le premier signal de commande (S_{Ti}), et à une sortie non inversée le second signal de commande (S_{T}), ladite seconde bascule (24) étant cadencée par un signal de cadencement fourni par le détecteur de passages par zéro (25), alors que la première bascule étant cadencée soit par le signal oscillant de l'oscillateur (40), soit par le signal de cadencement du détecteur de passages par zéro (25).

10. Dispositif (1) d'émission de signaux de données et/ou de commande, selon l'une des revendications 2, 5 et 8, **caractérisé en ce que** les premier, second et troisième générateurs de signaux (3, 4, 5) comprennent chacun un diviseur de fréquence (31, 41, 51) pour diviser par un premier facteur la fréquence du signal oscillant de l'oscillateur (40), afin de fournir un signal à fréquence divisée à un circuit d'entraînement (32, 42, 52), qui contrôle la fourniture de signaux à fréquence porteuse f0 aux premier, second et troisième agencements d'antenne (6, 7, 8), dans chaque état stable de modulation, **en ce que** le diviseur de fréquence (31) du premier générateur de signaux (3) peut être programmé par le premier signal de commande (S_{Ti}) fourni par le circuit de synchronisation (2), pour diviser la fréquence du signal oscillant par un second facteur différent du premier facteur, afin que le circuit d'entraînement (32) du premier générateur de signaux (3) contrôle la fourniture de signaux à la première fréquence f1 = f0-Δf au premier agencement d'antenne (6) dans une phase de transition d'état de modulation, et **en ce que** le diviseur de fréquence (51) du troisième générateur de signaux (5) peut être programmé par le premier signal de commande (S_{Ti}) fourni par le circuit de synchronisation (2), pour diviser la fréquence du signal oscillant par un troisième facteur différent des premier et second facteurs, afin que le circuit d'entraînement (52) du troisième générateur de signaux (5) contrôle la fourniture de signaux à la troisième fréquence f3 = f0+Δf au troisième agencement d'antenne (8) dans une phase de transition d'état de modulation.

11. Dispositif (1) d'émission de signaux de données et/ou de commande, selon l'une des revendications 2, 5 et 8, **caractérisé en ce que** le second générateur de signaux (4) comprend l'oscillateur (40), un multiplicateur de fréquence (43) pour multiplier par un facteur n1 la fréquence du signal oscillant de l'oscillateur, afin de fournir un signal à fréquence multipliée aux premier et troisième générateurs de signaux (3, 5), et un circuit d'entraînement (42) recevant le signal oscillant pour contrôler la fourniture de signaux à fréquence porteuse f0 au second agencement d'antenne (7), **en ce que** les premier et troisième générateurs de signaux comprennent chacun des première et second branches de division de la fréquence du signal à fréquence multipliée reçu du multiplicateur de fréquence (43), la première branche ou la seconde branche étant sélectionnée par le premier signal de commande (S_{Ti}) fourni par le circuit de synchronisation (2), dans la première branche de division, la fréquence pouvant être divisée par le facteur n1 pour que les circuits d'entraînement (32, 52) des premier et troisième générateurs de signaux contrôlent la fourniture de signaux à fréquence porteuse f0 aux premier et troisième agencements d'antenne (6, 8) dans un état stable de modulation, alors que dans la seconde branche de division, la fréquence peut être divisée par un facteur n2 différent du facteur n1 dans le premier générateur de signaux (3) et par un facteur n3 différent des facteurs n1 et n2 dans le troisième générateur de signaux (5), afin que le circuit d'entraînement (32) du premier générateur de signaux (3) gère la fourniture de signaux à la première fréquence f1 = f0-Δf = f0·n1/n2 au premier agencement d'antenne (6) dans la phase de transition d'état de modulation, et afin que le circuit d'entraînement (52) du troisième générateurs de signaux (5) gère la fourniture de signaux à la troisième fréquence f3 = f0+Δf = f0·n1/n3 au troisième agencement d'antenne (8) dans la phase de transition d'état de modulation.

12. Dispositif (1) d'émission de signaux de données et/ou de commande, selon la revendication 11, **caractérisé en ce que** la première branche de division des premier et troisième générateurs de signaux (3, 5) comprend chacune en entrée un inverseur (30, 50) de manière à sélectionner la première branche dans un premier état du premier signal de commande (S_{Ti}) et la seconde branche dans un second état du premier signal de commande (S_{Ti}).

13. Dispositif (1) d'émission de signaux de données et/ou de commande, selon la revendication 12, **caractérisé en ce que** la première branche de division des premier et troisième générateurs de signaux (3, 5) comprend une première porte ET (33), pour recevoir le signal de sortie de l'inverseur (30, 50) et le signal à fréquence multipliée du multiplicateur de fréquence (43), un premier compteur par n1 (35, 55) relié à la sortie de la première porte ET (33, 53), une seconde porte ET (37, 57) recevant à une première entrée le signal de sortie du premier compteur (35, 55) et le signal de sortie de l'inverseur (30, 50), une sortie de la seconde porte ET (37, 57) étant reliée par l'intermédiaire d'une porte OU (39, 59) au circuit d'entraînement (32, 52) pour la fourniture de signaux à fréquence porteuse f0 aux premier et troisième agencements d'antenne (6, 8), **en ce que** la seconde branche de division des premier et troisième générateurs de signaux (3, 5) comprend une troisième porte ET (34, 54) pour recevoir directement le premier signal de commande (S_{Ti}) à une première entrée et le signal à fréquence multipliée à une seconde entrée, un second compteur par n2 (36) pour le premier générateur de signaux (3) ou un second compteur par n3 (56) pour le troisième générateur de signaux (5) relié chacun à la sortie de la troisième porte ET (34, 54), une quatrième porte ET (38, 58) recevant à une première entrée le signal de sortie du second compteur par n2 (36) du premier générateur de signaux ou du second compteur par n3 (56) du troisième générateur de signaux, une sortie de la quatrième porte ET (38, 58) étant reliée par l'intermédiaire de la porte OU (39, 59) au circuit d'entraînement (32, 52) pour la fourniture de signaux à fréquence f1 pour le premier agencement d'antenne (6) et la fourniture de signaux à fréquence f3 pour le troisième agencement d'antenne (8) en phase de transition d'état de modulation.

14. Dispositif (1) d'émission de signaux de données et/ou de commande, selon l'une des revendications 10 et 11, **caractérisé en ce que** les circuits d'entraînement (32, 42, 52) sont agencés pour être contrôlés chacun par une unité de traitement, afin d'adapter l'amplitude des signaux transmis par les premier, second et/ou troisième agencements d'antenne.

15. Dispositif (1) d'émission de signaux de données et/ou de commande, selon la revendication 14, **caractérisé en ce que** le circuit d'entraînement (42) du second générateur de signaux (4) est agencé pour adapter l'amplitude des signaux transmis par le second agencement d'antenne (7) à un niveau deux fois supérieur à l'amplitude des signaux transmis par les premier et troisième agencements d'antenne (6, 8) et adaptée par les circuits d'entraînement (32, 52) des premier et troisième générateurs de signaux (3, 5).

16. Procédé de mise en action du dispositif (1) d'émission de signaux de données et/ou de commande, selon l'une des revendications précédentes 2-15, ledit procédé comprenant les étapes consistant à :
- fournir un signal de modulation (S_{mod}) des données et/ou de commande au circuit de synchronisation (2),
- contrôler de manière synchrone par l'intermédiaire du circuit de synchronisation (2) au moins le premier générateur de signaux (3) et/ou le troisième générateur de signaux (5), et les premier, second et troisième agencements d'antenne (6, 7, 8) pour opérer une modulation en amplitude des données et/ou de commande à transmettre à deux niveaux d'amplitude par combinaison des signaux transmis par les agencements d'antenne, un premier état stable de modulation à un premier niveau d'amplitude étant défini, quand les signaux transmis à une fréquence porteuse définie f0 par les premier, second et troisième agencements d'antenne sont en phase, et un second état stable de modulation à un second niveau d'amplitude étant défini, quand les signaux transmis à une fréquence porteuse définie f0 par les premier et troisième agencements d'antenne (6, 8) sont déphasés de 180° des signaux transmis à une fréquence porteuse définie f0 par le second agencement d'antenne (7),
- commuter temporairement et dynamiquement les premier et/ou troisième générateurs de signaux (3, 5) par l'intermédiaire du circuit de synchronisation (2) pour la fourniture au premier agencement d'antenne (6) de signaux à une première fréquence f1 inférieure ou supérieure à la fréquence porteuse f0 et pour la fourniture au troisième agencement d'antenne (8) de signaux à une troisième fréquence f3 supérieure ou inférieure à la fréquence porteuse f0 et inversement à la première fréquence f1 dans une phase de transition d'état de modulation et de manière synchrone sur la base de n cycles de signaux à la fréquence porteuse f0 transmis par le second agencement d'antenne et comptés dans le circuit de synchronisation (2), où n est un nombre entier, et
- adapter de manière inductive ou capacitive la fréquence de résonance du premier agencement d'antenne (6) à la fréquence f1 et/ou la fréquence de résonance du troisième agencement d'antenne (8) à la fréquence f3 durant la phase de transition d'état de modulation.

## Patentansprüche

1. Vorrichtung (1) zum Senden von Daten- und/oder Befehlssignalen, wobei die Vorrichtung umfasst:
- einen ersten Signalgenerator (3), der mit einer ersten Antennenanordnung (6) verbunden ist,
- einen zweiten Signalgenerator (4), der mit einer zweiten Antennenanordnung (7) verbunden ist,
- einen Oszillator (40) zum Liefern eines Oszillationssignals, um die Signalgeneratoren zu takten, um jede Antennenanordnung zu steuern, und
- eine Synchronisationsschaltung (2), die wenigstens mit dem ersten Signalgenerator (3) und der ersten und der zweiten Antennenanordnung (6, 7) verbunden ist, wobei die Synchronisationsschaltung (2) dazu vorgesehen ist, am Eingang ein Daten- und/oder Befehls-Modulationssignal (S_{mod}) zu empfangen und um den ersten Signalgenerator (3) und die erste und die zweite Antennenanordnung (6, 7) synchron zu steuern, um eine Amplitudenmodulation der Daten und/oder der Befehle, die mit zwei Amplitudenpegeln gesendet werden sollen, durch Kombinieren der von den Antennenanordnungen gesendeten Signale auszuführen, wobei ein erster stabiler Modulationszustand mit einem ersten Amplitudenpegel definiert wird, wenn die mit einer definierten Trägerfrequenz f0 durch die erste und die zweite Antennenanordnung gesendeten Signale in Phase sind, und ein zweiter stabiler Modulationszustand mit einem zweiten Amplitudenpegel definiert wird, wenn die mit einer definierten Trägerfrequenz f0 von der ersten Antennenanordnung (6) gesendeten Signale zu den Signalen, die mit einer definierten Trägerfrequenz f0 durch die zweite Antennenanordnung (7) gesendet werden, um 180°phasenverschoben sind,
**dadurch gekennzeichnet, dass** die Synchronisationsschaltung (2) dafür ausgelegt ist, den ersten Signalgenerator (3) für die Lieferung von Signalen an die erste Antennenanordnung (6) mit einer Frequenz f1, die größer oder kleiner als die Trägerfrequenz f0 ist, in einer Übergangsphase von einem ersten Modulationszustand zu einem zweiten Modulationszustand oder umgekehrt synchron auf der Grundlage von n Zyklen der Signale mit der Trägerfrequenz f0, die von der zweiten Antennenanordnung (7) gesendet werden, die in der Synchronisationsschaltung (2) gezählt werden, wobei n eine ganze Zahl ist, vorübergehend und dynamisch umzuschalten, und
dass die Synchronisationsschaltung (2) dafür ausgelegt ist, die Resonanzfrequenz der ersten Antennenanordnung (6) während der Übergangsphase von einem Modulationszustand in Bezug auf die bei der Trägerfrequenz f0 der ersten und der zweiten Antennenanordnung bestimmte Resonanzfrequenz in einen stabilen Modulationszustand an die Frequenz f1 der von dem ersten Signalgenerator (3) gelieferten Signale induktiv oder kapazitiv anzupassen.

2. Vorrichtung (1) zum Senden von Daten- und/oder Befehlssignalen nach Anspruch 1, **dadurch gekennzeichnet, dass** sie einen dritten Signalgenerator (5) umfasst, der mit einer dritten Antennenanordnung (8) verbunden ist, die durch die Synchronisationsschaltung (2) synchron gesteuert wird, um eine Amplitudenmodulation der zu sendenden Daten und/oder Befehls durch Kombinieren der von der ersten, der zweiten und der dritten Antennenanordnung (6, 7, 8) gesendeten Signale auszuführen, wobei ein erster stabiler Modulationszustand definiert wird, wenn die mit einer definierten Trägerfrequenz f0 durch die erste, die zweite und die dritte Antennenanordnung (6, 7, 8) gesendeten Signale in Phase sind, während ein zweiter stabiler Modulationszustand definiert wird, wenn die durch die erste und die dritte Antennenanordnung gesendeten Signale in Bezug auf die Signale, die von der zweiten Antennenanordnung gesendet werden, um 180° phasenverschoben sind,
dass die Synchronisationsschaltung (2) dafür ausgelegt ist, während jeder Modulationszustand-Übergangsphase den dritten Signalgenerator (5) für die Lieferung von Signalen an die dritte Antennenanordnung (8) mit einer Frequenz f3 = f0 + Δf vorübergehend und dynamisch umzuschalten, während die von dem ersten Signalgenerator (3) vorübergehend an die erste Antennenanordnung gelieferten Signale eine Frequenz f1 = f0 - Δf haben, wobei Δf einen bestimmten Frequenzabstand definiert, derart, dass (f0/Af)/2 die Anzahl n von Signalzyklen mit der Trägerfrequenz f0, die von der zweiten Antennenanordnung (7) gesendet werden, definiert, und
dass die Synchronisationsschaltung dafür ausgelegt ist, die Resonanz-frequenz der dritten Antennenanordnung (8) an die Frequenz f3 der Signale, die von dem dritten Signalgenerator (3) während der Modulationszustand-Übergangsphase geliefert werden, induktiv oder kapazitiv anzupassen.

3. Vorrichtung (1) zum Senden von Daten- und/oder Befehlssignalen nach Anspruch 2, **dadurch gekennzeichnet, dass** die Synchronisationsschaltung dafür ausgelegt ist, die Resonanzfrequenz der ersten und der dritten Antennenanordnung (6, 8) an die Frequenz f1 und an die Frequenz f3 zu einem Zeitpunkt, zu dem ein Strom für ein induktives Element 0 A beträgt oder eine Spannung für ein kapazitives Element 0 V beträgt, induktiv oder kapazitiv anzupassen.

4. Vorrichtung (1) zum Senden von Daten- und/oder Befehlssignalen nach Anspruch 2, **dadurch gekennzeichnet, dass** während der Modulations-zustand-Übergangsphase die von der ersten Antennenanordnung (6) gesendeten Signale eine Frequenz f1 = f0 · (n - 0,5)/n haben, während die von der dritten Antennenanordnung (8) gesendeten Signale eine Frequenz f3 = f0 · (n + 0,5)/n haben.

5. Vorrichtung (1) zum Senden von Daten- und/oder Befehlssignalen nach Anspruch 2, **dadurch gekennzeichnet, dass** die erste, die zweite und die dritte Antennenanordnung (6, 7, 8) jeweils in Reihe zwischen dem Ausgang des ersten, des zweiten bzw. des dritten Signalgenerators (3, 4, 5) einen Masseanschluss, einen Verlustwiderstand (R1, R2, R3), eine Induktivität (A1, A2, A3), die eine Antenne definiert, und wenigstens einen ersten Kondensator (C₁₁, C₂₁, C₃₁) umfassen, dass die erste Antennenanordnung (6) außerdem einen zweiten Kondensator (cm2) umfasst, der über einen ersten Ein/Aus-Schalter (9), der durch ein erstes Befehlssignal (S_{Ti}) der Synchronisationsschaltung (2) gesteuert werden kann, parallel zu dem ersten Kondensator (C₁₁) der ersten Antennenanordnung geschaltet werden kann, um die Resonanzfrequenz anzupassen, und dass die dritte Antennenanordnung (8) außerdem einen zweiten Kondensator (C₃₂) umfasst, der über einen zweiten Ein/Aus-Schalter (10), der durch ein zweites Befehlssignal (S_{T}) der Synchronisationsschaltung (2) gesteuert wird, parallel zu dem ersten Kondensator (C₃₁) der dritten Antennenanordnung geschaltet werden kann, um die Resonanzfrequenz anzupassen.

6. Vorrichtung (1) zum Senden von Daten- und/oder Befehlssignalen nach Anspruch 5, **dadurch gekennzeichnet, dass** das erste Befehlssignal (S_{Ti}) das Inverse des zweiten Befehlssignals (S_{T}) ist und dass das erste Befehlssignal dafür ausgelegt ist, den ersten Ein/Aus-Schalter in der Modulationszustand-Übergangsphase zu schließen, während das zweite Befehlssignal dafür ausgelegt ist, den zweiten Ein/Aus-Schalter (10) in der Modulationszustand-Übergangsphase zu öffnen.

7. Vorrichtung (1) zum Senden von Daten- und/oder Befehlssignalen nach Anspruch 5, **dadurch gekennzeichnet, dass** die Antennen (A1, A2, A3) der ersten, der zweiten und der dritten Antennenanordnung (6, 7, 8) in der Weise angeordnet sind, dass sie in dieselbe Richtung orientiert sind und ihre Achsen zueinander parallel sind, wobei die Abmessung der von den drei Antennen (A1, A2, A3) belegten Zone kleiner als die Wellenlänge der von den Antennen gesendeten Signale ist.

8. Vorrichtung (1) zum Senden von Daten- und/oder Befehlssignalen nach Anspruch 5, **dadurch gekennzeichnet, dass** die Synchronisationsschaltung (2) einen Nulldurchgangs-Detektor (25) umfasst, der mit einem Verbindungs-knoten zwischen der Antenne (A2) und dem ersten Kondensator (C₂₁) der zweiten Antennenanordnung (7) verbunden ist, um die Durchgänge durch null der Sinusspannung, die durch den ersten Kondensator erzeugt wird, zu detektieren, um die Lieferung des ersten und des zweiten Befehlssignals (S_{Ti}, S_{T}) an die erste und die dritte Antennenanordnung (6, 8) zu synchronisieren, um die Resonanz-frequenz anzupassen.

9. Vorrichtung (1) zum Senden von Daten- und/oder Befehlssignalen nach Anspruch 8, **dadurch gekennzeichnet, dass** die Synchronisationsschaltung (2) ein erstes D-Flipflop (21) umfasst, um am Eingang ein Modulationssignal (S_{mod}) zu empfangen, das von den zu sendenden Daten und/oder Befehlen abhängt, wobei ein nicht invertierter Ausgang des ersten Flipflops (21) mit einem ersten Eingang eines Exklusiv-ODER-Gatters (23) verbunden ist, während ein invertierter Ausgang des ersten Flipflops (21) mit einem Eingang eines n-Zählers (22) verbunden ist, wobei n eine ganze Zahl größer als 1 ist, die die Anzahl von zu zählenden Zyklen der Signale mit der Trägerfrequenz f0 definiert, die von der zweiten Antennenanordnung (7) gesendet werden, wobei ein Ausgang dieses Zählers (22) mit einem zweiten Eingang des Exklusiv-ODER-Gatters (23) verbunden ist, wobei ein Ausgang des Exklusiv-ODER-Gatters (23) mit einem Eingang eines zweiten D-Flipflops (24) verbunden ist, wobei das zweite Flipflop (24) an einem invertierten Ausgang das erste Befehlssignal (S_{Ti}) liefert und an einem nicht invertierten Ausgang das zweite Befehlssignal (S_{T}) liefert, wobei das zweite Flipflop (24) durch ein Taktsignal getaktet wird, das von dem Nulldurchgangsdetektor (25) geliefert wird, während das erste Flipflop entweder durch das Oszillationssignal des Oszillators (40) oder durch das Taktsignal des Nulldurchgangs-Detektors (25) getaktet wird.

10. Vorrichtung (1) zum Senden von Daten- und/oder Befehlssignalen nach einem der Ansprüche 2, 5 und 8, **dadurch gekennzeichnet, dass** der erste, der zweite und der dritte Signalgenerator (3, 4, 5) jeweils einen Frequenzteiler (31, 41, 51) umfassen, um die Frequenz des Oszillationssignals des Oszillators (40) durch einen ersten Faktor zu teilen, um ein Signal mit geteilter Frequenz an eine Treiberschaltung (32, 42, 52) zu liefern, die die Lieferung von Signalen mit Trägerfrequenz f0 an die erste, die zweite und die dritte Antennenanordnung (6, 7, 8) in jedem stabilen Modulationszustand steuert, dass der Frequenzteiler (31) des ersten Signalgenerators (3) durch das erste Befehlssignal (S_{Ti}), das von der Synchronisationsschaltung (2) geliefert wird, programmiert werden kann, um die Frequenz des Oszillationssignals durch einen von dem ersten Faktor verschiedenen zweiten Faktor zu teilen, damit die Treiberschaltung (32) des ersten Signalgenerators (3) die Lieferung von Signalen mit der ersten Frequenz f1 = f0 - Δf an die erste Antennenanordnung (6) in einer Modulationszustand-Übergangsphase steuert, und dass der Frequenzteiler (51) des dritten Signal-generators (5) durch das erste Befehlssignal (S_{Ti}) das von der Synchronisationsschaltung (2) geliefert wird, programmiert werden kann, um die Frequenz des Oszillationssignals durch einen von dem ersten und dem zweiten Faktor verschiedenen dritten Faktor zu teilen, damit die Treiberschaltung (52) des dritten Signalgenerators (5) die Lieferung von Signalen mit der dritten Frequenz f3 = f0 + Δf an die dritte Antennenanordnung (8) in einer Modulationszustand-Übergangsphase steuert.

11. Vorrichtung (1) zum Senden von Daten- und/oder Befehlssignalen nach einem der Ansprüche 2, 5 und 8, **dadurch gekennzeichnet, dass** der zweite Signalgenerator (4) einen Oszillator (40), einen Frequenzvervielfacher (43), um die Frequenz des Oszillationssignals des Oszillators mit einem Faktor n1 zu vervielfachen, um ein Signal mit vervielfachter Frequenz an den ersten und den dritten Signalgenerator (3, 5) zu liefern, und eine Treiberschaltung (42), die das Oszillationssignal empfängt, um die Lieferung von Signalen mit Trägerfrequenz f0 an die zweite Antennenanordnung (7) zu steuern, umfasst, dass der erste und der dritte Signalgenerator jeweils einen ersten und einen zweiten Frequenzteilungszweig für das Signal mit vervielfachter Frequenz, das von dem Frequenz-vervielfacher (43) empfangen wird, umfassen, wobei der erste Zweig oder der zweite Zweig von dem ersten Befehlssignal (S_{Ti}), das von der Synchronisationsschaltung (2) in dem ersten Teilungszweig geliefert wird, gewählt wird, wobei die Frequenz durch den Faktor n1 geteilt wird, damit die Treiberschaltungen (32, 52) des ersten und des dritten Signalgenerators die Lieferung von Signalen mit Trägerfrequenz f0 an die erste und die dritte Antennenanordnung (6, 8) in einem stabilen Modulationszustand steuern, während in dem zweiten Teilungszweig die Frequenz in dem ersten Signalgenerator (3) durch einen Faktor n2, der von dem Faktor n1 verschieden ist, geteilt werden kann und in dem dritten Signalgenerator (5) durch einen Faktor n3, der von den Faktoren n1 und n2 verschieden ist, geteilt werden kann, damit die Treiberschaltung (32) des ersten Signalgenerators (3) die Lieferung von Signalen mit der ersten Frequenz f1 = f0 - Δf = f0 · n1/n2 an die erste Antennenanordnung (6) in einer Modulationszustand-Übergangsphase steuert und damit die Treiberschaltung (52) des dritten Signalgenerators (5) die Lieferung von Signalen mit der dritten Frequenz f3 = f0 + Δf = f0 · n1/n3 an die dritte Antennenanordnung (8) in der Modulationszustand-Übergangsphase steuert.

12. Vorrichtung (1) zum Senden von Daten- und/oder Befehlssignalen nach Anspruch 11, **dadurch gekennzeichnet, dass** der erste Teilungszweig des ersten und des dritten Signalgenerators (3, 5) jeweils am Eingang einen Inverter (30, 50) umfasst, derart, dass in einem ersten Zustand des ersten Befehlssignals (S_{Ti}) der erste Zweig gewählt wird und in einem zweiten Zustand des ersten Befehissignals (S_{Ti}) der zweite Zweig gewählt wird.

13. Vorrichtung (1) zum Senden von Daten- und/oder Befehlssignalen nach Anspruch 12, **dadurch gekennzeichnet, dass** der erste Teilungszweig des ersten und des dritten Signalgenerators (3, 5) umfasst: ein erstes UND-Gatter (33), um das Ausgangssignal des Inverters (30, 50) und das Signal mit vervielfachter Frequenz des Frequenzvervielfachers (43) zu empfangen, einen ersten n1-Zähler (35, 55), der mit dem Ausgang des ersten UND-Gatters (33, 53) verbunden ist, und ein zweites UND-Gatter (37, 57), das an einem ersten Eingang das Ausgangssignal des ersten Zählers (35, 55) und das Ausgangssignal des Inverters (30, 50) empfängt, wobei ein Ausgang des zweiten UND-Gatters (37, 57) über ein ODER-Gatter (39, 59) mit der Treiberschaltung (32, 52) verbunden ist, um Signale mit Trägerfrequenz f0 an die erste und die dritte Antennenanordnung (6, 8) zu liefern, dass der zweite Teilungszweig des ersten und des dritten Signalgenerators (3, 5) umfasst: ein drittes UND-Gatter (34, 54), um direkt das erste Befehlssignal (S_{Ti}) an einem ersten Eingang zu empfangen und direkt das Signal mit vervielfachter Frequenz an einem zweiten Eingang zu empfangen, einen zweiten n2-Zähler (36) für den ersten Signalgenerator (3) oder einen zweiten n3-Zähler (56) für den dritten Signalgenerator (5), der jeweils mit dem Ausgang des dritten UND-Gatters (34, 54) verbunden ist, und ein viertes UND-Gatter (38, 58), das an einem ersten Eingang das Ausgangssignal des zweiten n2-Zählers (36) des ersten Signalgenerators oder des zweiten n3-Zählers (56) des dritten Signalgenerators empfängt, wobei ein Ausgang des vierten UND-Gatters (38, 58) über das ODER-Gatter (39, 59) mit der Treiberschaltung (32, 52) verbunden ist, um Signale mit Frequenz f1 für die erste Antennenanordnung (6) und Signale mit Frequenz f3 für die dritte Antennenanordnung (8) in der Modulationszustand-Übergangsphase zu liefern.

14. Vorrichtung (1) zum Senden von Daten- und/oder Befehlssignalen nach einem der Ansprüche 10 und 11, **dadurch gekennzeichnet, dass** die Treiberschaltungen (32, 42, 52) dafür ausgelegt sind, jeweils durch eine Verarbeitungseinheit gesteuert zu werden, um die Amplitude der von der ersten, der zweiten und/oder der dritten Antennenanordnung gesendeten Signale anzupassen.

15. Vorrichtung (1) zum Senden von Daten- und/oder Befehlssignalen nach Anspruch 14, **dadurch gekennzeichnet, dass** die Treiberschaltung (42) des zweiten Signalgenerators (4) dafür ausgelegt ist, die Amplitude der von der zweiten Antennenanordnung (7) gesendeten Signale an einen Pegel anzupassen, der zweimal größer als die Amplitude der Signale ist, die von der ersten und der dritten Antennenanordnung (6, 8) gesendet werden, die durch die Treiber-schaltungen (32, 52) des ersten und des dritten Signalgenerators (3, 5) angepasst wird.

16. Verfahren zum Betreiben der Vorrichtung (1) zum Senden von Daten- und/oder Befehlssignalen nach einem der Ansprüche 2 bis 15, wobei das Verfahren die Schritte umfasst, die darin bestehen:
- ein Daten- und/oder Befehls-Modulationssignal (S_{mod}) an die Synchronisationsschaltung (2) zu liefern,
- über die Synchronisationsschaltung (2) wenigstens den ersten Signalgenerator (3) und den dritten Signalgenerator (5) und die erste, die zweite und die dritte Antennenanordnung (6, 7, 8) synchron zu steuern, um eine Amplitudenmodulation von Daten und/oder Befehlen, die mit zwei Amplituden-pegeln gesendet werden sollen, durch Kombinieren von Signalen, die von den Antennenanordnungen gesendet werden, auszuführen, wobei ein erster stabiler Modulationszustand mit einem ersten Amplitudenpegel definiert wird, wenn die mit einer definierten Trägerfrequenz f0 von der ersten, der zweiten und der dritten Antennenanordnung gesendeten Signale in Phase sind, und ein zweiter stabiler Modulationszustand mit einem zweiten Amplitudenpegel definiert wird, wenn die mit einer definierten Trägerfrequenz f0 von der ersten und der dritten Antennenanordnung (6, 8) gesendeten Signale in Bezug auf die Signale, die mit einer definierten Trägerfrequenz f0 von der zweiten Antennenanordnung (7) gesendet werden, um 180° phasenverschoben sind,
- den ersten und den dritten Signalgenerator (3, 5) über die Synchronisationsschaltung (2) vorübergehend und dynamisch umzuschalten, um an die erste Antennenanordnung (6) Signale mit einer ersten Frequenz f1, die kleiner oder größer als die Trägerfrequenz f0 ist, zu liefern und um an die dritte Antennenanordnung (8) Signale mit einer dritten Frequenz f3, die größer oder kleiner als die Trägerfrequenz f0 und umgekehrt zu der ersten Frequenz f1 ist, in einer Modulationszustand-Übergangsphase und synchron auf der Grundlage von n Zyklen von Signalen mit der Trägerfrequenz f0, die von der zweiten Antennenanordnung gesendet werden, die in der Synchronisationsschaltung (2) gezählt werden, wobei n eine ganze Zahl ist, zu liefern, und
- die Resonanzfrequenz der ersten Antennenanordnung (6) induktiv oder kapazitiv an die Frequenz f1 anzupassen und die Resonanzfrequenz der dritten Antennenanordnung (8) während der Modulationszustand-Übergangsphase induktiv oder kapazitiv an die Frequenz f3 anzupassen.

## Claims

1. Data and/or command signal transmission device (1), the device including:
- a first signal generator (3) connected to a first antenna arrangement (6),
- a second signal generator (4) connected to a second antenna arrangement (7),
- an oscillator (40) for delivering an oscillating signal, in order to clock the signal generators to control each antenna arrangement, and
- a synchronisation circuit (2) connected at least to the first signal generator (3) and to the first and second antenna arrangements (6, 7), the synchronisation circuit (2) being arranged to receive at input a data and/or command modulation signal (S_{mod}) and to control, in a synchronous manner, the first signal generator (3) and the first and second antenna arrangements (6, 7) to perform amplitude modulation on the data and/or command to be transmitted on two amplitude levels by a combination of the signals transmitted by the antenna arrangements, a first stable modulation state on a first amplitude level being defined when the signals transmitted at a defined carrier frequency f0 by the first and second antenna arrangements are in-phase, and a second stable modulation state on a second amplitude level being defined when the signals transmitted at a defined carrier frequency f0 by the first antenna arrangement (6) are 180° out of phase from the signals transmitted at a defined carrier frequency f0 by the second antenna arrangement (7),
**characterized in that** the synchronisation circuit (2) is arranged to temporarily and dynamically switch the first signal generator (3) for the delivery of signals to the first antenna arrangement (6) at a frequency f1 higher or lower than the carrier frequency f0 in a transition phase from a first modulation state to a second modulation state or vice versa in a synchronous manner on the basis of n signal cycles at the carrier frequency f0 transmitted by the second antenna arrangement (7) and counted in the synchronisation circuit (2), where n is an integer number, and
**in that** the synchronisation circuit (2) is arranged to adapt, in an inductive or capacitive manner, the resonance frequency of the first antenna arrangement (6) to frequency f1 of the signals delivered by the first signal generator (3) during the modulation state transition phase relative to the resonance frequency determined at the carrier frequency f0 of the first and second antenna arrangements in a stable modulation state.

2. Data and/or command signal transmission device (1) according to claim 1, **characterized in that** the device includes a third signal generator (5) connected to a third antenna arrangement (8), which are controlled in a synchronous manner by the synchronisation circuit (2), to perform amplitude modulation on the data and/or command to be transmitted by a combination of the signals transmitted by the first, second and third antenna arrangements (6, 7, 8), a first stable modulation state being defined when the signals transmitted at a defined carrier frequency f0 by the first, second and third antenna arrangements (6, 7, 8) are in-phase, while a second stable modulation state is defined when the signals transmitted by the first and third antenna arrangements are 180° out of phase from the signals transmitted by the second antenna arrangement,
**in that** the synchronisation circuit (2) is arranged to temporarily and dynamically switch, during each modulation state transition phase, the third signal generator (5) for the delivery of signals to the third antenna arrangement (8) at a frequency f3 = f0+Δf, whereas the signals temporarily delivered by the first signal generator (3) to the first antenna arrangement are at a frequency f1 = f0-Δf, where Δf defines a frequency deviation determined such that (f0/Δf)/2 defines the number n of signal cycles at the carrier frequency f0 transmitted by the second antenna arrangement (7), and
**in that** the synchronisation circuit (2) is arranged to adapt, in an inductive or capacitive manner, the resonance frequency of the third antenna arrangement (8) to frequency f3 of the signals delivered by the third signal generator (3) during the modulation state transition phase.

3. Data and/or command signal transmission device (1) according to claim 2, **characterized in that** the synchronisation circuit is arranged to adapt, in an inductive or capacitive manner, the resonance frequency of the first and third antenna arrangements (6, 8) to frequency f1 and to frequency f3 at a moment when a current is at 0 A for an inductive element or a voltage is at 0 V for a capacitive element.

4. Data and/or command signal transmission device (1) according to claim 2, **characterized in that** the signals transmitted by the first antenna arrangement (6) are at a frequency f1 = f0·(n-0.5)/n during the modulation state transition phase, while the signals transmitted by the third antenna arrangement (8) are at a frequency f3 = f0·(n+0.5)/n.

5. Data and/or command signal transmission device (1) according to claim 2, **characterized in that** the first, second and third antenna arrangements (6, 7, 8) each include, in series between the output of the first, second and third signal generators (3, 4, 5) and an earth terminal, a loss resistor (R1, R2, R3), an inductance (A1, A2, A3) defining an antenna and at least a first capacitor (C₁₁, C₂₁, C₃₁), **in that** the first antenna arrangement (6) further includes a second capacitor (C₁₂) able to be placed in parallel to the first capacitor (C₁₁) of the first antenna arrangement via a first switch (9) controlled by a first command signal (S_{Ti}) of the synchronisation circuit (2) to adapt the resonance frequency, and **in that** the third antenna arrangement (8) further includes a second capacitor (C₃₂) able to be placed in parallel to the first capacitor (C₃₁) of the third antenna arrangement via a second switch (10) controlled by a second command signal (S_{T}) of the synchronisation circuit (2) to adapt the resonance frequency.

6. Data and/or command signal transmission device (1) according to claim 5, **characterized in that** the first command signal (S_{Ti}) is the inverse of the second command signal (S_{T}), and **in that** the first command signal is arranged to close the first switch in the modulation state transition phase, while the second command signal is arranged to open the second switch (10) in the modulation state transition phase.

7. Data and/or command signal transmission device (1) according to claim 5, **characterized in that** the antennas (A1, A2, A3) of the first, second and third antenna arrangements (6, 7, 8) are disposed so as to be oriented in the same direction, with the axes thereof parallel to each other, the dimension of the area occupied by the three antennas (A1, A2, A3) being smaller than the wavelength of the signals transmitted by the antennas.

8. Data and/or command signal transmission device (1) according to claim 5, **characterized in that** the synchronisation circuit (2) includes a zero crossing detector (25) connected to a connection node between the antenna (A2) and the first capacitor (C₂₁) of the second antenna arrangement (7), to detect the zero crossings of the sinusoidal voltage generated across the first capacitor, in order to synchronise the delivery of the first and second command signals (S_{Ti}, S_{T}) to the first and third antenna arrangements (6, 8) to adapt the resonance frequency.

9. Data and/or command signal transmission device (1) according to claim 8, **characterized in that** the synchronisation circuit (2) includes a first D-type flip-flop (21) for receiving at input a modulation signal (S_{mod}) dependent on the data and/or command to be transmitted, a non-inverted output of the first flip-flop (21) being connected to a first input of an Exclusive-OR gate (23), while an inverted output of the first flip-flop (21) is connected to an input of a counter-by-n (22), where n is an integer number greater than 1 defining the number of cycles to be counted of the signals at carrier frequency f0 transmitted by the second antenna arrangement (7), an output of said counter (22) being connected to a second input of the Exclusive-OR gate (23), an output of the Exclusive-OR gate (23) being connected to an input of a second D-type flip-flop (24), the second flip-flop (24) delivering the first command signal (S_{Ti}) at an inverted output, and the second command signal (S_{T}) at a non-inverted output, said second flip-flop (24) being clocked by a clocking signal delivered by the zero crossing detector (25), while the first flip-flop is clocked either by the oscillating signal of the oscillator (40), or by the clocking signal of the zero crossing detector (25).

10. Data and/or command signal transmission device (1) according to any of claims 2, 5 and 8, **characterized in that** the first, second and third signal generators (3, 4, 5) each include a frequency divider (31, 41, 51) for dividing, by a first factor, the frequency of the oscillating signal from the oscillator (40), so as to deliver a divided frequency signal to a drive circuit (32, 42, 52), which controls the delivery of signals at carrier frequency f0 to the first, second and third antenna arrangements (6, 7, 8) in each stable modulation state, **in that** the frequency divider (31) of the first signal generator (3) may be programmed by the first command signal (S_{Ti}) delivered by the synchronisation circuit (2), to divide the frequency of the oscillating signal by a second factor, different from the first factor, so that the drive circuit (32) of the first signal generator (3) controls the delivery of signals at the first frequency f1 = f0-Δf to the first antenna arrangement (6) in a modulation state transition phase, and **in that** the frequency divider (51) of the third signal generator (5) may be programmed by the first command signal (S_{Ti}) delivered by the synchronisation circuit (2), to divide the frequency of the oscillating signal by a third factor, different from the first and second factors, so that the drive circuit (52) of the third signal generator (5) controls the delivery of signals at the third frequency f3 = f0+Δf to the third antenna arrangement (8) in a modulation state transition phase.

11. Data and/or command signal transmission device (1) according to any of claims 2, 5 and 8, **characterized in that** the second signal generator (4) includes the oscillator (40), a frequency multiplier (43) for multiplying, by a factor n1, the frequency of the oscillating signal from the oscillator, so as to deliver a multiplied frequency signal to the first and third signal generators (3, 5), and a drive circuit (42) receiving the oscillating signal to control the delivery of signals at carrier frequency f0 to the second antenna arrangement (7), **in that** the first and third signal generators each include first and second frequency division branches for the multiplied frequency signal received from the frequency multiplier (43), the first branch or the second branch being selected by the first command signal (S_{Ti}) delivered by the synchronisation circuit (2), in the first division branch, the frequency being able to be divided by factor n1 so that the drive circuits (32, 52) of the first and third signal generators control the delivery of signals at carrier frequency f0 to the first and third antenna arrangements (6, 8) in a stable modulation state, while in the second division branch, the frequency may be divided by a factor n2 different from factor n1 in the first signal generator (3) and by a factor n3 different from factors n1 and n2 in the third signal generator (5), so that the drive circuit (32) of the first signal generator (3) controls the delivery of signals at first frequency f1 = f0-Δf = f0·n1/n2 to the first antenna arrangement (6) in the modulation state transition phase, and so that the drive circuit (52) of the third signal generator (5) controls the delivery of signals at third frequency f3 = f0+·f = f0·n1/n3 to the third antenna arrangement (8) in the modulation state transition phase.

12. Data and/or command signal transmission device (1) according to claim 11, **characterized in that** the first division branch of the first and third signal generators (3, 5) each has at input an inverter (30, 50) so as to select the first branch in a first state of the first command signal (S_{Ti}), and the second branch in a second state of the first command signal (S_{Ti}).

13. Data and/or command signal transmission device (1) according to claim 12, **characterized in that** the first division branch of the first and third signal generators (3, 5) includes a first AND gate (33) for receiving the inverter (30, 50) output signal and the multiplied frequency signal from the frequency multiplier (43), a first counter-by-n1 (35, 55) connected to the output of the first AND gate (33, 53), a second AND gate (37, 57) receiving at a first input the output signal from the first counter (35, 55) and the output signal from the inverter (30, 50), an output of the second AND gate (37, 57) being connected via an OR gate (39, 59) to the drive circuit (32, 52) for the delivery of signals at carrier frequency f0 to the first and third antenna arrangements (6, 8), **in that** the second division branch of the first and third signal generators (3, 5) includes a third AND gate (34, 54) for directly receiving the first command signal (S_{Ti}) at a first input and the multiplied frequency signal at a second input, a second counter-by-n2 (36) for the first signal generator (3) or a second counter-by-n3 (56) for the third signal generator (5) each connected to the output of the third AND gate (34, 54), a fourth AND gate (38, 58) receiving at a first input the output signal from the second counter-by-n2 (36) of the first signal generator or from the second counter-by-n3 (56) of the third signal generator, an output of the fourth AND gate (38, 58) being connected via the OR gate (38, 59) to the drive circuit (32, 52) for the delivery of signals at frequency f1 for the first antenna arrangement (6) and the delivery of signals at frequency f3 for the third antenna arrangement (8) in modulation state transition phase.

14. Data and/or command signal transmission device (1) according to any of claims 10 and 11, **characterized in that** the drive circuits (32, 42, 52) are each arranged to be controlled by a processing unit, so as to adapt the amplitude of the signals transmitted by the first, second and/or third antenna arrangements.

15. Data and/or command signal transmission device (1) according to claim 14, **characterized in that** the drive circuit (42) of the second signal generator (4) is arranged to adapt the amplitude of the signals transmitted by the second antenna arrangement (7) to a level two times higher than the amplitude of the signals transmitted by the first and third antenna arrangements (6, 8) and adapted by the drive circuits (32, 52) of the first and third signal generators (3, 5).

16. Method of actuating the data and/or command signal transmission device (1) according to any of preceding claims 2 to 15, said method including the steps consisting in:
- delivering a data and/or command modulation signal (S_{mod}) to the synchronisation circuit (2),
- synchronously controlling via the synchronisation circuit (2) at least the first signal generator (3) and the third signal generator (5), and the first, second and third antenna arrangements (6, 7, 8) to perform amplitude modulation on the data and/or command to be transmitted on two amplitude levels by combining the signals transmitted by the antenna arrangements, a first stable modulation state on a first amplitude level being defined when the signals transmitted at a defined carrier frequency f0 by the first, second and third antenna arrangements are in-phase, and a second stable modulation state on a second amplitude level being defined when the signals transmitted at a defined carrier frequency f0 by the first and third antenna arrangements (6, 8) are 180° out of phase from the signals transmitted at a defined carrier frequency f0 by the second antenna arrangement (7),
- temporarily and dynamically switching the first and third signal generators (3, 5) via the synchronisation circuit (2) for the delivery to the first antenna arrangement (6) of signals at a first frequency f1 lower or higher than the carrier frequency f0 and for the delivery to the third antenna arrangement (8) of signals at a third frequency f3 higher or lower than the carrier frequency f0 and conversely to the first frequency f1 in a modulation state transition phase and synchronously on the basis of n cycles of signals at carrier frequency f0 transmitted by the second antenna arrangement and counted in the synchronisation circuit (2) where n is an integer number, and
- adapting, in an inductive or capacitive manner, the resonance frequency of the first antenna arrangement (6) to frequency f1 and the resonance frequency of the third antenna arrangement (8) to frequency f3 during the modulation state transition phase.
A method of actuating the data and/or command signal transmission device (1) according to claim 2, said method including the steps consisting in:
- delivering a data and/or command modulation signal (S_{mod}) to the synchronisation circuit (2),
- synchronously controlling via the synchronisation circuit (2) at least the first signal generator (3) and the third signal generator (5), and the first, second and third antenna arrangements (6, 7, 8) to perform amplitude modulation on the data and/or command to be transmitted on at least two amplitude levels by combining the signals transmitted by the antenna arrangements, a first stable modulation state on a first amplitude level being defined when the signals transmitted at a defined carrier frequency f0 by the first, second and/or third antenna arrangements are in-phase, and a second stable modulation state on a second amplitude level being defined when the signals transmitted at a defined carrier frequency f0 by the first and third antenna arrangements (6, 8) are 180° out of phase from the signals transmitted at a defined carrier frequency f0 by the second antenna arrangement (7),
- temporarily and dynamically switching the first and third signal generators (3, 5) via the synchronisation circuit (2) for the delivery to the first antenna arrangement (6) of signals at a first frequency f1 lower or higher than the carrier frequency f0, and for the delivery to the third antenna arrangement (8) of signals at a third frequency f3 higher or lower than carrier frequency f0 and inversely to the first frequency f1 in a modulation state transition phase and synchronously on the basis of n cycles of signals at carrier frequency f0 transmitted by the second antenna arrangement and counted in the synchronisation circuit (2), and
- adapting, in an inductive or capacitive manner, the resonance frequency of the first antenna arrangement (6) to frequency f1 and the resonance frequency of the third antenna arrangement (8) to frequency f3 during the modulation state transition phase.
